# EUROPEAN PATENT APPLICATION

(11) **EP 2 544 220 A1**
(43) Date of publication of application: **09.01.2013**
(21) Application number: 11750815.0
(22) Date of filing: 04.03.2011
(51) Int. Cl.: H01L 21/20, C30B 29/20, C30B 33/02, H01L 21/268

(54) **SINGLE CRYSTAL SUBSTRATE, PRODUCTION METHOD FOR SINGLE CRYSTAL SUBSTRATE, PRODUCTION METHOD FOR SINGLE CRYSTAL SUBSTRATE WITH MULTILAYER FILM, AND DEVICE PRODUCTION METHOD**

(30) Priority: 05.03.2010 JP 2010049859
(71) Applicant: Namiki Seimitsu Houseki kabushikikaisha, Adachi-ku Tokyo 123-8511 (JP); Disco Corporation, Tokyo 143-8580 (JP)
(72) Inventor: AIDA, Hideo, Tokyo 123-8511 (JP); AOTA, Natsuko, Tokyo 123-8511 (JP); HOSHINO, Hitoshi, Tokyo 143-8580 (JP); FURUTA, Kenji, Tokyo 143-8580 (JP); HAMAMOTO, Tomosaburo, Tokyo 143-8580 (JP); HONJO, Keiji, Tokyo 143-8580 (JP)
(74) Representative: Skone James, Robert Edmund
(86) International application number: PCT/JP2011/055076
(87) International publication number: WO 2011/108706

(57) **Abstract**

In order to correct warpage resulting from the formation of a multilayer film, provided are a single crystal substrate which includes a heat-denatured layer provided in one of two regions including a first region (10D) and a second region (10U) obtained by bisecting the single crystal substrate in a thickness direction thereof, and which is warped convexly toward a side of a surface of the region provided with the heat-denatured layer, a manufacturing method for the single crystal substrate, a manufacturing method for a single crystal substrate with a multilayer film using the single crystal substrate, and an element manufacturing method using the manufacturing method for a single crystal substrate with a multilayer film.

## Description

### Technical Field

The present invention relates to a single crystal substrate, a manufacturing method for the single crystal substrate, a manufacturing method for a single crystal substrate with a multilayer film, and an element manufacturing method.

### Background Art

A nitride semiconductor represented by gallium nitride (GaN) has a wide band gap and is capable of blue light emission, and hence the nitride semiconductor is widely used in a light emitting diode (LED), a semiconductor laser (LD), and the like. In recent years, an effort to further increase the luminous efficiency and luminance has been actively made.

The structure of a typical nitride semiconductor light emitting element has a double hetero structure in which, on a sapphire substrate, a buffer layer made of GaN, an n-type contact layer made of n-type GaN, an n-type cladding layer made of n-type AlGaN, an active layer made of n-type InGaN, a p-type cladding layer made of p-type AlGaN, and a p-type contact layer made of p-type GaN are stacked in this order. The active layer contains In of a single quantumwell (SQW) structurehavingonlyawell layer made of InxGa1-xN (0≤X≤1) or a multi-quantum well (MQW) structure having the well layer made of InxGa1-xN (0≤X≤1) and a barrier layer made of InyGa1-yN (0≤y≤1, y<x) (see Patent Literature 1).

It is known that, when the above-mentioned multilayer film is formed on the sapphire substrate, warpage occurs in the sapphire substrate after the film formation due to differences in thermal expansion coefficient and lattice constant between the multilayer film and sapphire. For example, Non Patent Literature 1 discloses the result of a study in which an AlN buffer layer and a GaN layer are epitaxially grown on a sapphire substrate to determine how a thermal stress generated by the film formation is relieved depending on the film thickness of the GaN layer. Non Patent Literature 1 reveals that the warpage of the substrate is increased as the film thickness is increased, and interference defects, microcracks, dislocation, or macrocracks occur correspondingly to the increase, and accordingly the stress is relieved.

In addition, FIG. 4 of Non Patent Literature 2 discloses an analysis method in which the warpage of a substrate occurring through the step of epitaxially growing a GaN-based LED structure on a sapphire substrate is observed in situ. According to this method, it is revealed that, in a series of film formation steps, the curvature of the sapphire substrate significantly changes due to changes in film forming substance, film formation temperature, and film thickness. Further, it is revealed that, by adopting the film formation steps that allow the curvature of the sapphire substrate to become substantially 0 at the stage of the growth of the InGaN layer as the active layer, the emission wavelength in the surface of the substrate is uniformed.

As has been described above, it is known that the warpage of the sapphire substrate significantly changes through a series of film formation steps, and the quality of the nitride semiconductor film and the uniformity of the emission wavelength are thereby affected. Note that, in reality, the warpage shape and the warpage amount of the sapphire substrate are often set so that the substrate curvature becomes substantially 0 in the InGaN-based active layer by utilizing a difference in thermal expansion coefficient from that of the substrate. With the background described above, in order to control the shape and the warpage amount of the sapphire substrate, various polishing technologies are studied (see Patent Literature 2 and the like).

On the other hand, a technology is known in which, when a light emitting element obtained by stacking nitride semiconductor on a sapphire substrate is divided, a pulsed laser is concentrated onto the internal portion of the sapphire substrate having a thickness of about 80 µm to 90 µm to form a reformed region corresponding to a line for division of the light emitting element (Patent Literature 3). The technology disclosed in Patent Literature 3 is a method of processing the sapphire substrate capable of suppressing a reduction in the luminance of the light emitting element even when the substrate is divided into the individual light emitting elements by applying a laser beam to the sapphire substrate, and an object of the technology is the division of the light emitting element.

### Citation List

### Patent Literature

[PTL 1] JP 3250438 B
[PTL 2] JP 2006-347776 A
[PTL 3] JP 2008-6492 A

### Non Patent Literature

[NPL1] Jpn. J. Appl. Phys. Vol. 32, (1993), pp. 1528-1533 [NPL 2] J. Cryst. Growth. Vol. 272, Issues 1-4, (2004), pp. 94-99

### Summary of Invention

### Technical Problem

As has been described above, when, in order to produce various elements such as the light emitting element, the multilayer film in accordance with the element structure is formed on a single crystal substrate such as the sapphire substrate, the substrate after the film formation (single crystal substrate with a multilayer film) is usually warped. On the other hand, in the manufacturing of the element, various subsequent steps are usually further performed on the single crystal substrate with a multilayer film. However, when the subsequent steps are performed in a state in which the substrate with a multilayer film is warped, this has led to variations in quality and a reduction in yield of the element.

For example, when a patterning process is performed on the multilayer film in the subsequent step, the following problem occurs. That is, when the patterning process is performed on the multilayer film, a resist formed on the multilayer film is exposed by using a photomask. At this time, the single crystal substrate with a multilayer film is in a warped state. Therefore, when the focal point of light irradiated for the exposure is set on the surface of the multilayer film positioned at the central portion of the single crystal substrate, the surface of the multilayer film positioned in the vicinity of the end portion of the single crystal substrate becomes out of focus. In this case, variations in exposure occur in the surface of the multilayer film, which lead to variations in quality and a reduction in yield of the element manufactured by performing the subsequent steps.

In addition, in the subsequent step, when the surface of the single crystal substrate with a multilayer film opposite to the surface having the multilayer film formed thereon is to be polished (back lapping process), the surface of the single crystal substrate with a multilayer film having the multilayer film formed thereon needs to be bonded and fixed to a flat polishing board. However, in this case, when the single crystal substrate with a multilayer film is warped, in order to flatten the surface to be subjected to the back lapping process, it is necessary for the bonding process to apply a large pressure to the single crystal substrate with a multilayer film at the time of the bonding. However, as the warpage becomes larger, a larger pressure needs to be applied. As a result, a crack becomes likely to occur in the substrate with a multilayer film, and the yield is thereby reduced. In order to avoid the occurrence of the above-mentioned problem, it can be conceived to use a thicker single crystal substrate. However, in this method, a polishing amount required for the back lapping process is increased and a polishing time period is prolonged, and hence productivity is lowered and the method lacks practicality.

On the other hand, in a case where the above-mentioned single crystal substrate with a multilayer film is manufactured, in general, the multilayer film is formed by using a substantially flat single crystal substrate with almost no warpage. When the multilayer film is formed on one surface of the single crystal substrate, a stress balance between regions on both sides of a line bisecting the single crystal substrate in a thickness direction thereof is lost by an internal stress resulting from the multilayer film. As a result, it can be said that, when the formation of the multilayer film is completed, the single crystal substrate is warped. In view of the above-mentioned circumstances, it is desirable that a substrate warped in advance be used as the single crystal substrate to be used in manufacturing the single crystal substrate with a multilayer film so that the warpage resulting from the formation of the multilayer film is corrected at the time point when the formation of the multilayer film is ended.

In addition, the above-mentioned warpage occurs at the stage of the film formation step of forming the multilayer film on the single crystal substrate. When fluctuations in warpage behavior of the single crystal substrate during the film formation step are sharp, variations in film thickness and/or film quality occur in each layer constituting the multilayer film. The variations in film thickness and/or film quality have caused variations in quality and a reduction in yield of the above-mentioned various elements.

The present invention has been made in view of the above-mentioned circumstances, and an object thereof is to provide a single crystal substrate capable of correcting warpage resulting from the formation of a multilayer film, a manufacturing method for the single crystal substrate, a manufacturing method for a single crystal substrate with a multilayer film using the single crystal substrate, and an element manufacturing method using the manufacturing method for a single crystal substrate with a multilayer film.

### Solution to Problem

The above-mentioned object is attained by the present invention as follows.

Specifically, according to the present invention, there is provided a single crystal substrate, including a heat-denatured layer provided in one of two regions including a first region and a second region obtained by bisecting the single crystal substrate in a thickness direction of the single crystal substrate, in which the single crystal substrate is warped convexly toward a side of a surface of the one of the two regions provided with the heat-denatured layer.

Further, in a single crystal substrate according to an embodiment of the present invention, the one of the two regions provided with the heat-denatured layer is preferably the first region.

Further, in a single crystal substrate according to another embodiment of the present invention, the one of the two regions provided with the heat-denatured layer is preferably the second region.

Further, in a single crystal substrate according to still another embodiment of the present invention, when a relative position of the heat-denatured layer in the thickness direction of the single crystal substrate is assumed to be 0% at a surface on a side of the first region and 100% at a surface on a side of the second region, the heat-denatured layer is preferably provided in a range of 5% or more and less than 50% in the thickness direction of the single crystal substrate.

Further, in a single crystal substrate according to still another embodiment of the present invention, when a relative position of the heat-denatured layer in the thickness direction of the single crystal substrate is assumed to be 0% at a surface on a side of the first region and 100% at a surface on a side of the second region, the heat-denatured layer is preferably provided in a range of more than 50% and 95% or less in the thickness direction of the single crystal substrate.

Further, in a single crystal substrate according to still another embodiment of the present invention, the heat-denatured layer is preferably formed by laser irradiation.

Further, in a single crystal substrate according to still another embodiment of the present invention, the heat-denatured layer is preferably provided in parallel to both surfaces of the single crystal substrate.

Further, in a single crystal substrate according to still another embodiment of the present invention, in a planar direction of the single crystal substrate, the heat-denatured layer is preferably provided to have at least one pattern shape selected from the following shapes:
i) a shape in which a plurality of polygons identical in shape and size are regularly disposed;
ii) a shape in which a plurality of circles or ellipses identical in shape and size are regularly disposed;
iii) a concentric shape;
iv) a shape formed so as to be substantially point-symmetric with respect to a center point of the single crystal substrate;
v) a shape formed so as to be substantially linearly-symmetric with respect to a straight line passing through the center point of the single crystal substrate;
vi) a stripe shape; and
vii) a spiral shape.

Further, in a single crystal substrate according to still another embodiment of the present invention, the shape in which the plurality of polygons identical in shape and size are regularly disposed is preferably a lattice shape.

Further, in a single crystal substrate according to still another embodiment of the present invention, the lattice shape is preferably formed of a pattern in which a pitch between lines constituting the pattern is in a range of 50 µm to 2,000 µm.

Further, in a single crystal substrate according to still another embodiment of the present invention, the single crystal substrate preferably has a curvature in a range of 200 km⁻¹ or less.

Further, in a single crystal substrate according to still another embodiment of the present invention, a material of the single crystal substrate is preferably sapphire.

Further, in a single crystal substrate according to still another embodiment of the present invention, the single crystal substrate preferably has a diameter of 50 mm or more and 300 mm or less.

Further, in a single crystal substrate according to still another embodiment of the present invention, the single crystal substrate preferably has a thickness of 0.05 mm or more and 5.0 mm or less.

Further, according to the present invention, there is provided a manufacturing method for a single crystal substrate, including performing at least a heat-denatured layer formation step in which a heat-denatured layer is formed in one of two regions including a first region and a second region obtained by bisecting a single crystal substrate in a thickness direction of the single crystal substrate, the heat-denatured layer being formed by irradiating a laser from a side of one surface of the single crystal substrate before a laser irradiation process, thereby manufacturing the single crystal substrate which is warped convexly toward a side of a surface of the one of the two regions provided with the heat-denatured layer.

Further, in a manufacturing method for a single crystal substrate according to an embodiment of the present invention, the region in which the heat-denatured layer is formed is preferably the first region.

Further, in a manufacturing method for a single crystal substrate according to another embodiment of the present invention, it is preferred to irradiate the laser to the single crystal substrate from a surface of the single crystal substrate on a side of the first region.

Further, in a manufacturing method for a single crystal substrate according to still another embodiment of the present invention, the region in which the heat-denatured layer is formed is preferably the second region.

Further, in a manufacturing method for a single crystal substrate according to still another embodiment of the present invention, it is preferred to irradiate of the laser to the single crystal substrate from a surface of the single crystal substrate on a side of the second region.

Further, in a manufacturing method for a single crystal substrate according to still another embodiment of the present invention, it is preferred to perform the laser irradiation so as to satisfy at least one of irradiation conditions A and B described below.

### <Irradiation Condition A>

- laser wavelength: 200 nm to 350 nm
- pulse width: order of nanoseconds

### <Irradiation Condition B>

- laser wavelength: 350 nm to 2,000 nm
- pulse width: order of femtoseconds to order of picoseconds

Further, according to the present invention, there is provided a manufacturing method for a single crystal substrate with a multilayer film, the single crystal substrate including a heat-denatured layer provided in one of two regions including a first region and a second region obtained by bisecting the single crystal substrate in a thickness direction of the single crystal substrate, the single crystal substrate being warped convexly toward a side of a surface of the one of the two regions provided with the heat-denatured layer, the manufacturing method including performing at least a multilayer film formation step in which a multilayer film including two or more layers is formed on a surface of the single crystal substrate on a side of the second region.

Further, in a manufacturing method for a single crystal substrate with a multilayer film according to an embodiment of the present invention, the region in which the heat-denatured layer is formed is preferably the first region.

Further, in a manufacturing method for a single crystal substrate with a multilayer film according to another embodiment of the present invention, it is preferred to form the heat-denatured layer, when a relative position of the heat-denatured layer in the thickness direction of the single crystal substrate is assumed to be 0% at a surface on a side of the first region and 100% at a surface on a side of the second region, so as to be positioned in a range of 5% or more and less than 50% in the thickness direction of the single crystal substrate.

Further, in a manufacturing method for a single crystal substrate with a multilayer film according to still another embodiment of the present invention, the region in which the heat-denatured layer is formed is preferably the second region.

Further, in a manufacturing method for a single crystal substrate with a multilayer film according to still another embodiment of the present invention, it is preferred to form the heat-denatured layer, when a relative position of the heat-denatured layer in the thickness direction of the single crystal substrate is assumed to be 0% at a surface on a side of the first region and 100% at a surface on a side of the second region, so as to be positioned in a range of more than 50% and 95% or less in the thickness direction of the single crystal substrate.

Further, in a manufacturing method for a single crystal substrate with a multilayer film according to still another embodiment of the present invention, it is preferred to perform at least a heat-denatured layer formation step in which the heat-denatured layer is formed in the first region of the two regions including the first region and the second region obtained by bisecting the single crystal substrate in the thickness direction of the single crystal substrate, the heat-denatured layer being formed by irradiating a laser from a side of one surface of the single crystal substrate, thereby producing the single crystal substrate which is warped convexly toward the side of the surface of the first region, and to thereafter perform the multilayer film formation step on the single crystal substrate.

Further, in a manufacturing method for a single crystal substrate with a multilayer film according to still another embodiment of the present invention, it is preferred to irradiate the laser to the single crystal substrate from the surface of the single crystal substrate on the side of the first region.

Further, in a manufacturing method for a single crystal substrate with a multilayer film according to still another embodiment of the present invention, it is preferred to perform at least a heat-denatured layer formation step in which the heat-denatured layer is formed in the second region of the two regions including the first region and the second region obtained by bisecting the single crystal substrate in the thickness direction of the single crystal substrate, the heat-denatured layer is formed in the first region by irradiating a laser from a side of one surface of the single crystal substrate, thereby producing the single crystal substrate which is convexly warped toward the side of the surface of the second region, and to thereafter perform the multilayer film formation step on the single crystal substrate.

Further, in a manufacturing method for a single crystal substrate with a multilayer film according to still another embodiment of the present invention, it is preferred to irradiate of the laser to the single crystal substrate from a surface of the single crystal substrate on a side of the second region.

In a manufacturing method for a single crystal substrate with a multilayer film according to still another embodiment of the present invention, it is preferred to perform the laser irradiation so as to satisfy at least one of irradiation conditions A and B described below.

### <Irradiation Condition A>

- laser wavelength: 200 nm to 350 nm
- pulse width: order of nanoseconds

### <Irradiation Condition B>

- laser wavelength: 350 nm to 2,000 nm
- pulse width: order of femtoseconds to order of picoseconds

Further, in a manufacturing method for a single crystal substrate with a multilayer film according to still another embodiment of the present invention, it is preferred to form the heat-denatured layer so as to be in parallel to the multilayer film.

Further, in a manufacturing method for a single crystal substrate with a multilayer film according to still another embodiment of the present invention, it is preferred to form, in a planar direction of the single crystal substrate, the heat-denatured layer so as to have at least one pattern shape selected from the following shapes:
i) a shape in which a plurality of polygons identical in shape and size are regularly disposed;
ii) a shape in which a plurality of circles or ellipses identical in shape and size are regularly disposed;
iii) a concentric shape;
iv) a shape formed so as to be substantially point-symmetric with respect to a center point of the single crystal substrate;
v) a shape formed so as to be substantially linearly-symmetric with respect to a straight line passing through the center point of the single crystal substrate;
vi) a stripe shape; and
vii) a spiral shape.

Further, in a manufacturing method for a single crystal substrate with a multilayer film according to still another embodiment of the present invention, the shape in which the plurality of polygons identical in shape and size are regularly disposed is preferably a lattice shape.

Further, in a manufacturing method for a single crystal substrate with a multilayer film according to still another embodiment of the present invention, it is preferred to form the lattice shape into a pattern in which a pitch between lines constituting the pattern is in a range of 50 µm to 2,000 µm.

Further, in a manufacturing method for a single crystal substrate with a multilayer film according to still another embodiment of the present invention, the single crystal substrate provided with the heat-denatured layer before the formation of the multilayer film preferably has a curvature in a range of 200 km⁻¹ or less.

Further, in a manufacturing method for a single crystal substrate with a multilayer film according to still another embodiment of the present invention, a material of the single crystal substrate is preferably sapphire.

Further, in a manufacturing method for a single crystal substrate with a multilayer film according to still another embodiment of the present invention, the single crystal substrate preferably has a diameter of 50 mm or more and 300 mm or less.

Further, in a manufacturing method for a single crystal substrate with a multilayer film according to still another embodiment of the present invention, the single crystal substrate preferably has a thickness of 0.05 mm or more and 5.0 mm or less.

Further, in a manufacturing method for a single crystal substrate with a multilayer film according to another embodiment of the present invention, at least one of the two or more layers constituting the multilayer film is preferably a nitride semiconductor crystal layer.

Further, according to the present invention, there is provided an element manufacturing method, including: performing at least a multilayer film formation step in which a multilayer film including two or more layers is formed on a surface of a single crystal substrate on a side of a second region, thereby manufacturing a single crystal substrate with a multilayer film, the single crystal substrate including a heat-denatured layer provided in one of two regions including a first region and the second region obtained by bisecting the single crystal substrate in a thickness direction of the single crystal substrate, the single crystal substrate being warped convexly toward a side of a surface of the one of the two regions provided with the heat-denatured layer; and performing at least an element portion formation step of performing at least a patterning process on the multilayer film of the single crystal substrate with a multilayer film to produce an element portion functioning as an element selected from the group consisting of a light emitting element, a photovoltaic element, and a semiconductor element, thereby manufacturing the element including the element portion and the single crystal substrate having a size substantially corresponding to a size of the element portion.

### Advantageous Effects of Invention

According to the present invention described above, it is possible to provide the single crystal substrate capable of correcting the warpage resulting from the formation of the multilayer film, the manufacturing method for the single crystal substrate, the manufacturing method for the single crystal substrate with a multilayer film using the single crystal substrate, and the element manufacturing method using the manufacturing method for the single crystal substrate with a multilayer film.

### Brief Description of Drawings

[FIG. 1] A schematic explanatory diagram illustrating an example of a manufacturing method for a single crystal substrate according to an embodiment of the present invention.
[FIG. 2] A schematic explanatory diagram illustrating the example of the manufacturing method for a single crystal substrate according to the embodiment of the present invention, corresponding to the example illustrated in FIG. 1.
[FIG. 3] A schematic cross-sectional view illustrating an example of a warpage state of a single crystal substrate with a multilayer film obtained after a multilayer film is formed on a conventional substantially flat single crystal substrate without warpage.
[FIG. 4] A schematic cross-sectional view illustrating an example of a warpage state of a single crystal substrate with a multilayer film obtained after a multilayer film is formed on the single crystal substrate according to the embodiment of the present invention.

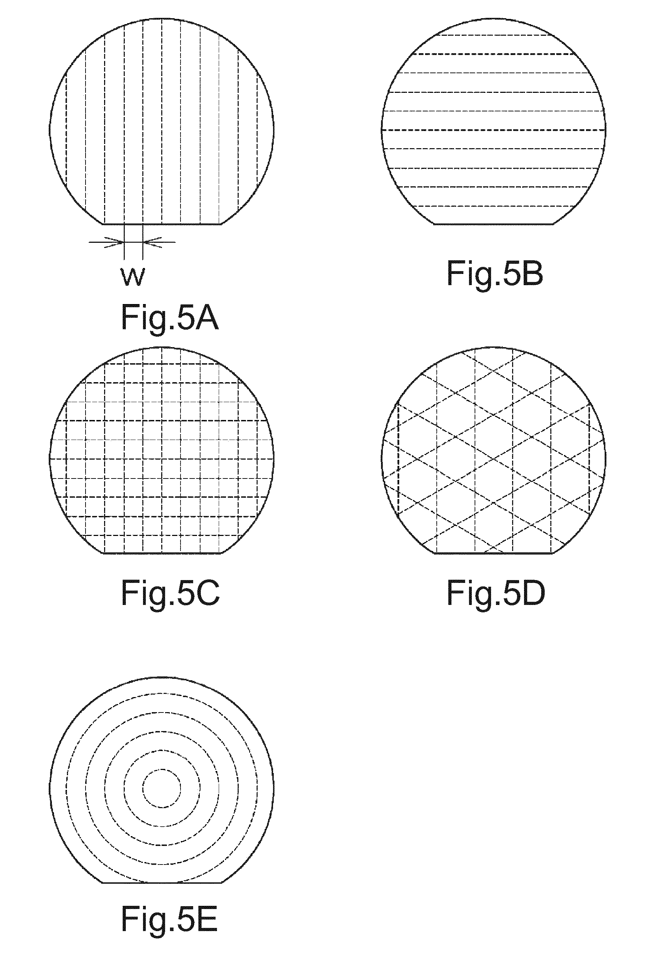

[FIGS. 5] Plan views illustrating examples of a disposition pattern shape of a heat-denatured layer in a planar direction of the single crystal substrate, of which FIG. 5A is a plan view illustrating a stripe shape in which a plurality of lines are formed perpendicular to an orientation flat plane of the substrate, FIG. 5B is a plan view illustrating a stripe shape in which a plurality of lines are formed in parallel to the orientation flat plane of the substrate, FIG. 5C is a plan view illustrating a lattice shape in which the disposition pattern shapes illustrated in FIGS. 5A and 5B are combined, FIG. 5D is a plan view illustrating a shape in which a plurality of regular hexagons identical in size are regularly disposed so that each of six vertices of each regular hexagon always coincides with any one of vertices of an adjacent regular hexagon, and FIG. 5E is a plan view illustrating a concentric shape.
[FIGS. 6] Schematic explanatory diagrams illustrating an example of a multilayer film formation step, of which FIG. 6A illustrates a state before film formation is started, FIG. 6B illustrates a state after a low-temperature buffer layer is formed, FIG. 6C illustrates a state after an n-GaN layer is formed, and FIG. 6D illustrates a state after an InGaN-based active layer having a multi-quantum well structure is formed.
[FIG. 7] A graph showing an example of a warpage behavior of the single crystal substrate in the multilayer film formation step.
[FIG. 8] A schematic explanatory diagram illustrating a method of calculating a warpage amount of a substrate from a curvature of the circular substrate.
[FIGS. 9] Schematic explanatory diagrams illustrating an example of an element manufacturing method according to the embodiment of the present invention, of which FIG. 9A illustrates an element portion formation step, FIG. 9B illustrates a polishing step, FIG. 9C illustrates a line-for-division formation step, and FIG. 9D illustrates a division step.
[FIG. 10] A graph showing the depth of the heat-denatured layer and the curvature change amount in a single crystal substrate after laser processing on which laser irradiation is performed from the surface on the side of a first region.
[FIG. 11] A graph showing the warpage behavior of the single crystal substrate in a step of forming an AlN film and an LT-GaN film according to the embodiment of the present invention.
[FIG. 12] A graph showing an example of the warpage behavior of the single crystal substrate in the step of forming the multilayer film on the single crystal substrate in which the heat-denatured layer is formed in a second region.
[FIG. 13] A schematic explanatory diagram illustrating an example of a manufacturing method for a single crystal substrate according to another aspect of the embodiment of the present invention.
[FIG. 14] A graph showing the depth of the heat-denatured layer and the curvature change amount in the single crystal substrate after laser processing on which the laser irradiation is performed from the surface on the side of the second region.

### Reference Signs List

- 10A: single crystal substrate before laser processing
- 10B: single crystal substrate after laser processing
- 10C: substrate after polishing
- 10D: first region
- 10U: second region
- 10R: region on side on which laser irradiation apparatus 30 is disposed (region corresponding to first region 10D)
- 12: non-film formation surface
- 12A: non-film formation surface after polishing
- 20, 20A, 20B, 20C, 20D: heat-denatured layer
- 28, 28A, 28B, 28C, 28D: heat-denatured layer
- 30: laser irradiation apparatus
- 30A, 30B, 30C: single crystal substrate with multilayer film
- 40: multilayer film
- 42: element portion
- 50: sapphire substrate after laser processing
- 52: film formation surface
- 54: non-film formation surface
- 60: low-temperature buffer layer
- 62: n-GaN layer
- 64: GaN-based layer
- 64A: InGaN-based active layer
- 64B: GaN-based barrier layer
- 64C: AlGaN-based barrier layer
- 70: multilayer film
- 80: polishing board
- 90: line for division
- 100: element

### Description of Embodiments

### (Single crystal substrate, manufacturing method for single crystal substrate, and manufacturing method for single crystal substrate with multilayer film)

A single crystal substrate according to an embodiment of the present invention (hereinafter, simply referred to as "substrate" as needed) has a feature that a heat-denatured layer is provided in one of two regions including a first region and a second region obtained by bisecting the substrate in a thickness direction thereof, and that the substrate is warped convexly toward the side of a surface of the region provided with the heat-denatured layer. In addition, a manufacturing method for a single crystal substrate with a multilayer film according to this embodiment using the single crystal substrate according to this embodiment has a feature that the single crystal substrate with a multilayer film is manufactured by performing at least a multilayer film formation step in which a multilayer film including two or more layers is formed on a surface of the single crystal substrate according to this embodiment on the side of the second region. The region provided with the heat-denatured layer is set to be one of the first region and the second region.

Herein, it is possible to correct the warpage resulting from the formation of the multilayer film in a case where the multilayer film is formed by using the single crystal substrate accordingtothisembodiment. Inthiscase, itisbasicallydesirable that the single crystal substrate with a multilayer film become as flat as possible through the correction of the warpage, but it is sufficient that the degree of the warpage is slightly reduced while the direction of the warpage resulting from the formation of the multilayer film remains unchanged. Alternatively, the warpage resulting from the formation of the multilayer film may be corrected so that the direction of the warpage resulting from the formation of the multilayer film is reversed and the single crystal substrate is warped in the opposite direction. Note that, in a case where the single crystal substrate with a multilayer film becomes substantially flat through the correction of the warpage resulting from the formation of the multilayer film, when the element is produced by performing the subsequent step after the formation of the multilayer film on the single crystal substrate according to this embodiment, it becomes easier to suppress variations in quality or improve the yield of the element than in a case where the element is produced by performing the subsequent step after the formation of the multilayer film on the conventional single crystal substrate.

In the case where the multilayer film is formed by using the single crystal substrate according to this embodiment, the reason why the warpage resulting from the multilayer film can be corrected is that the heat-denatured layer is provided in the first region of the single crystal substrate according to this embodiment, and the multilayer film is formed on the surface on the side of the second region at the time of the formation of the multilayer film.

As has been described above, through formation of the multilayer film on the warped single crystal substrate according to this embodiment so as to cancel out the warpage, it is possible to correct the warpage of the single crystal substrate with a multilayer film resulting from the multilayer film. Note that, from this, it is expected that, even when the single crystal substrate having a curved shape similar to that of the substrate warped by polishing is used instead of the single crystal substrate that is warped by forming the heat-denatured layer, it is possible to achieve the same effect as that described above. However, normal polishing is performed on a flat substrate, and hence it is extremely difficult to produce the single crystal substrate having the curved shape similar to that of the substrate warped by polishing. In addition, when lens polishing is utilized, it is possible to easily obtain the single crystal substrate having the curved shape similar to that of the substrate warped by polishing. However, in this case, a crystal plane exposed on the polished surface varies in the surface of the substrate. On the other hand, inacasewherethefilmformation is performed on the single crystal substrate for the purpose of producing some sort of an element, in general, a crystalline film is epitaxially grown in many cases by utilizing the crystal plane exposed on the surface of the single crystal substrate. In view of the need for the above-mentioned single crystal substrate, it is hardly conceivable, in the first place, to form the multilayer film by using the single crystal substrate curved by the lens polishing, which lacks practicality and flexibility.

In addition, it is also expected that it is possible to obtain the same effect as that described above by, besides the polishing, warping the substrate by forming a composition denatured layer on the surface of the single crystal substrate through ion implantation. However, ion implantation is limited to a region in the vicinity of the substrate surface, and hence the control range of the warpage of the single crystal substrate is expected to be extremely smaller as compared with a case where the heat-denatured layer is provided at an arbitrary position in the first region. In addition to this, ion implantation needs to be performed under a reduced pressure environment, and hence productivity thereof is extremely low. In view of the above-mentioned points, the method using ion implantation seems to extremely lack practicality.

Note that, the "heat-denatured layer" to be formed in the single crystal substrate according to this embodiment refers to a layer formed by locally heating a region in a part of the single crystal substrate. When the heat-denatured layer is formed in one of regions obtained by bisecting the single crystal substrate in the thickness direction, the heat-denatured layer has the action of warping the single crystal substrate so that the surface on the side of the region on which the heat-denatured layer is formed becomes convex.

A formation method for the heat-denatured layer is not particularly limited, but usually there is used a method in which the single crystal substrate is irradiated with a laser. In this case, by multiphoton absorption of atoms present in a region irradiated with the laser, the region is locally heated and some sort of denaturalization such as a change in crystal structure or crystallinity with respect to that in the surrounding region occurs. Accordingly, the heat-denatured layer is formed. That is, it is possible to manufacture the single crystal substrate according to this embodiment that is warped convexly toward the side of the surface of the first region by performing at least a heat-denatured layer formation step in which the heat-denatured layer is formed in the first region of the two regions including the first region and the second region obtained by bisecting the substrate in the thickness direction thereof, the heat-denatured layer being formed by irradiating the laser from the side of one surface of the single crystal substrate before a laser irradiation process. Subsequently, after the heat-denatured layer formation step, a multilayer film formation step is performed. Note that, from the viewpoint of suppressing the absorption loss of laser light, when the heat-denatured layer is formed in the first region, usually, the laser irradiation is preferably performed from the surface on the side of the first region, but the laser irradiation may also be performed from the surface on the side of the second region as needed.

### -Laser Irradiation Condition-

Note that, the irradiation of the laser may be performed under any irradiation condition as long as the heat-denatured layer can be formed. However, in general, it is preferred to use a pulsed laser that intermittently emits laser light because the pulsed laser can concentrate energy in a short time width and hence can obtain a high peak output. Thus, the irradiation of the pulsed laser is preferably performed in ranges 1) and 2) described below.
1) laser wavelength: 200 nm to 5,000 nm
2) pulse width: the order of femtoseconds to the order of nanoseconds (1 fs to 1,000 ns)

Herein, the laser wavelength and the pulse width are appropriately selected in consideration of the light transmittance/light absorption performance resulting from the material of the single crystal substrate as the target of the laser irradiation, the size and pattern precision of the heat-denatured layer formed in the single crystal substrate, and a practically usable laser apparatus. However, in the laser irradiation, it is especially preferable to select Irradiation Condition A described below.

### <Irradiation Condition A>

- laser wavelength: 200 nm to 350 nm
- pulse width: the order of nanoseconds (1 ns to 1,000 ns).
   Note that, more preferably, 10 ns to 15 ns.

### <Irradiation Condition B>

- laser wavelength: 350 nm to 2,000 nm
- pulse width: the order of femtoseconds to the order of picoseconds (1 fs to 1,000 ps). Note that, more preferably, 200 fs to 800 fs.

Note that, in Irradiation Condition A, the laser having the wavelength shorter than that in Irradiation Condition B is used. As a result, when the laser irradiation is performed under the same conditions except for the laser wavelength and the pulse width, Irradiation Condition A can reduce a laser process time period required to obtain substantially the same level of the effect of correcting the warpage as compared with Irradiation Condition B. In addition, as the laser wavelength to be used, it is suitable to select a wavelength longer than an absorption edge wavelength of the single crystal substrate as the target of the laser irradiation.

Herein, when the single crystal substrate is a sapphire substrate, Irradiation Condition A or B described above can be used. In this case, conditions other than the laser wavelength and the pulse width are preferably selected in ranges described below from the viewpoint of, for example, practicality and mass productivity.
- pulse rate: 50 kHz to 500 kHz
- laser power: 0.05 W to 0.8 W
- laser spot size: 0.5 µm to 4.0 µm (more preferably, approximately 2 µm)
- scanning speed of sample stage: 100 mm/s to 1,000 mm/s

Herein, when the single crystal substrate is an Si substrate, Irradiation Condition B described above can be used. In this case, conditions other than the laser wavelength are preferably selected in ranges described below from the viewpoint of, for example, practicality and mass productivity.
- pulse width: 50 ns to 200 ns
- pulse rate: 10 kHz to 500 kHz
- irradiation energy: 3 µJ to 12 µJ
- laser spot size: 0.5 µm to 4.0 µm
- scanning speed of sample stage: 50 mm/s to 1, 000 mm/s (morepreferably 100 mm/s to 1,000 mm/s)

Further, when the single crystal substrate is a GaAs substrate, Irradiation Condition B described above can be used. In this case, conditions other than the laser wavelength are preferably selected in ranges described below from the viewpoint of, for example, practicality and mass productivity.
- pulse width: 30 ns to 80 ns
- pulse rate: 10 kHz to 500 kHz
- irradiation energy: 8 µJ to 20 µJ
- laser spot size: 0.5 µm to 4.0 µm
- scanning speed of sample stage: 50 mm/s to 1, 000 mm/s (morepreferably 100 mm/s to 1,000 mm/s)

Further, when the single crystal substrate is a crystal substrate, Irradiation Condition B described above can be used. In this case, conditions other than the laser wavelength are preferably selected in ranges described below from the viewpoint of, for example, practicality and mass productivity.
- pulse width: 200 fs to 800 fs
- pulse rate: 10 kHz to 500 kHz
- irradiation energy: 3 µJ to 6 µJ
- laser spot size: 0.5 µm to 4.0 µm
- scanning speed of sample stage: 50 mm/s to 1, 000 mm/s (morepreferably 100 mm/s to 1,000 mm/s)

Note that, Table 1 shows examples of laser irradiation conditions when the heat-denatured layer is formed in each of an Si substrate, a GaAs substrate, and a crystal substrate. When the laser irradiation is performed, the surface of the single crystal substrate on the side to be irradiated with the laser is especially preferably in the state of a mirror plane (surface roughness Ra of approximately 1 nm or less). In order to bring the surface to be irradiated with the laser into the state of the mirror plane, for example, mirror polishing can be performed.

**[Table 1]**

| | Si | GaAs | Crystal |
|---|---|---|---|
| Wavelength (nm) | 1, 064 | 1, 064 | 1, 045 |
| Pulse width (sec) | 120×10⁻⁹ | 70×10⁻⁹ | 500×10⁻¹⁵ |
| Pulse rate (kHz) | 100 | 15 | 100 |
| Spot size (µm) | 1.5 | 1.5 | 1 |
| Laser power (W) | 0.3 to 1.2 | 0.2 | 0.4 |
| Stage scanning speed (mm/s) | 200 to 300 | 200 | 400 |

In addition, with provision of the heat-denatured layer in the second region of the single crystal substrate according to this embodiment, fluctuations in warpage behavior of the single crystal substrate occurring during the film formation step of forming the multilayer film on the single crystal substrate are suppressed, and the warpage of the single crystal substrate at an arbitrary film formation stage during the film formation step can be reduced to 0. Consequently, in each layer constituting the multilayer film, the occurrence of variations in film thickness and/or film quality is prevented. Due to the prevention of variations in film thickness and/or film quality, variations in quality and a reduction in yield of various elements are prevented. A method of forming the heat-denatured layer provided in the second region is not particularly limited, but usually, a method in which laser irradiation is performed on the single crystal substrate is used. It is possible to produce a single crystal substrate according to another embodiment of the present invention that is warped convexly toward the side of the surface of the second region by performing at least the heat-denatured layer formation step in which the heat-denatured layer is formed in the second region. After the heat-denatured layer formation step, the multilayer film formation step is performed. Note that, from the viewpoint of suppressing the absorption loss of the laser light, when the heat-denatured layer is formed in the second region, usually, the laser irradiation is preferably performed from the surface on the side of the second region, but the laser irradiation may also be performed from the surface on the side of the first region as needed.

### -Specific example of heat-denatured layer formation step-

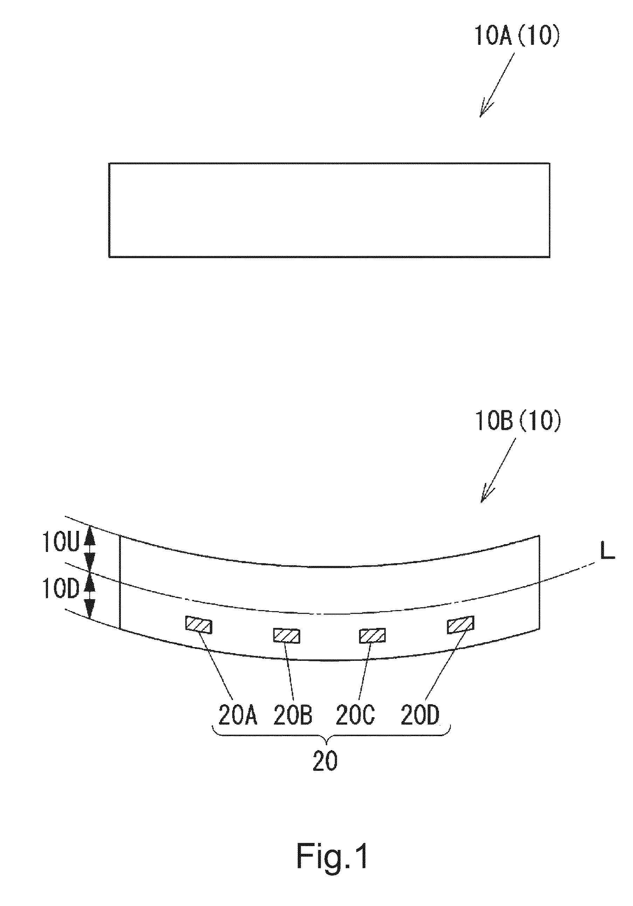

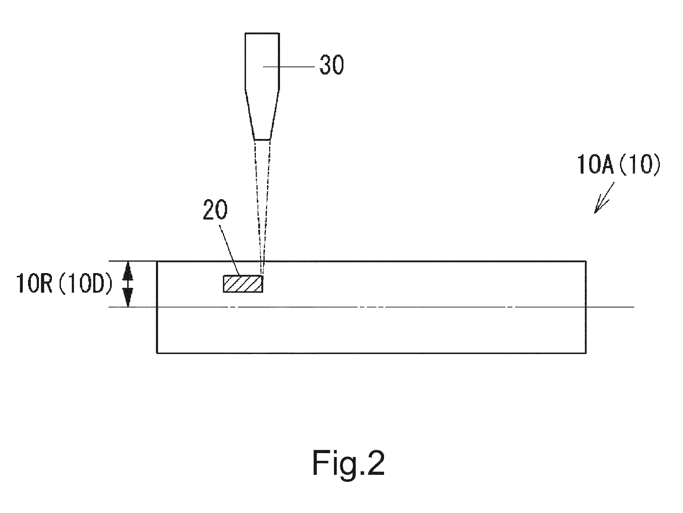

Next, a specific example of the heat-denatured layer formation step is described with reference to the drawings. Each of FIGS. 1 and 2 is a schematic explanatory diagram illustrating an example of a manufacturing method for a single crystal substrate according to this embodiment. Specifically, each of FIGS. 1 and 2 is a schematic explanatory diagram illustrating an example of the heat-denatured layer formation step. The upper part of FIG. 1 is a schematic cross-sectional view illustrating the single crystal substrate before the heat-denatured layer formation step is performed, while the lower part of FIG. 1 is a schematic cross-sectional view illustrating the single crystal substrate after the heat-denatured layer formation step is performed. In addition, FIG. 2 is a schematic cross-sectional view illustrating a state during the heat-denatured layer formation step, that is, a state in which a laser is irradiated from the one surface (surface on the side of the first region) of the single crystal substrate.

As illustrated in the upper part of FIG. 1, the conventional single crystal substrate before the heat-denatured layer formation step (single crystal substrate before laser processing 10A) is performed has no warpage and has a substantially flat shape. In contrast to this, the single crystal substrate according to this embodiment after the heat-denatured layer formation step (single crystal substrate after laser processing 10B) is performed, which is illustrated in the lower part of FIG. 1, is warped convexly toward the side of the surface of a first region 10D. In addition, as illustrated in the lower part of FIG. 1, of the first region 10D and a second region 10U obtained by bisecting the single crystal substrate after laser processing 10B in the thickness direction thereof along a one-dot chain line L, a plurality of heat-denatured layers 20 (20A, 20B, 20C, 20D) having a predetermined thickness are formed in the first region 10D at regular intervals in the planar direction of the single crystal substrate after laser processing 10B. Notethat,inthefollowing description, the single crystal substrate 10 may be used in some cases to refer to both or one of the single crystal substrate before laser processing 10A and the single crystal substrate after laser processing 10B.

Herein, as one example illustrated in FIG. 2, the heat-denatured layer formation step is performed in a state in which the single crystal substrate before laser processing 10A is fixed to a sample stage (not shown). Note that, the fixing is preferably performed through, for example, vacuum suction or the like. Subsequently, from a surface opposite to the side on which the sample stage of the single crystal substrate before laser processing 10A fixed to the sample stage is disposed, the laser is irradiated by a laser irradiation apparatus 30. At this time, the laser is concentrated onto the internal portion of a region 10R of the single crystal substrate before laser processing 10A, of two regions obtained by bisecting the single crystal substrate before laser processing 10A in a thickness direction thereof, on the side on which the laser irradiation apparatus 30 is disposed, that is, the region corresponding to the first region 10D. Further, the laser irradiation apparatus 30 and the single crystal substrate before laser processing 10A are moved relative to each other in the horizontal direction. In this manner, the heat-denatured layer 20 is formed. Here, through appropriate selection of the spot size, laser power, and pulse width of the laser, it is possible to control the degree of denaturalization and the size of the heat-denatured layer 20 in the planar direction and the thickness direction of the single crystal substrate after laser processing 10B. In addition, through appropriate selection of the movement speed of the laser irradiation apparatus 30 relative to the single crystal substrate before laser processing 10A (for example, when the sample stage is movable, the scanning speed of the sample stage) and the pulse rate of the laser, it is possible to control intervals between individual heat-denatured layers 20A, 20B, 20C, and 20D in the planar direction of the single crystal substrate after laser processing 10B.

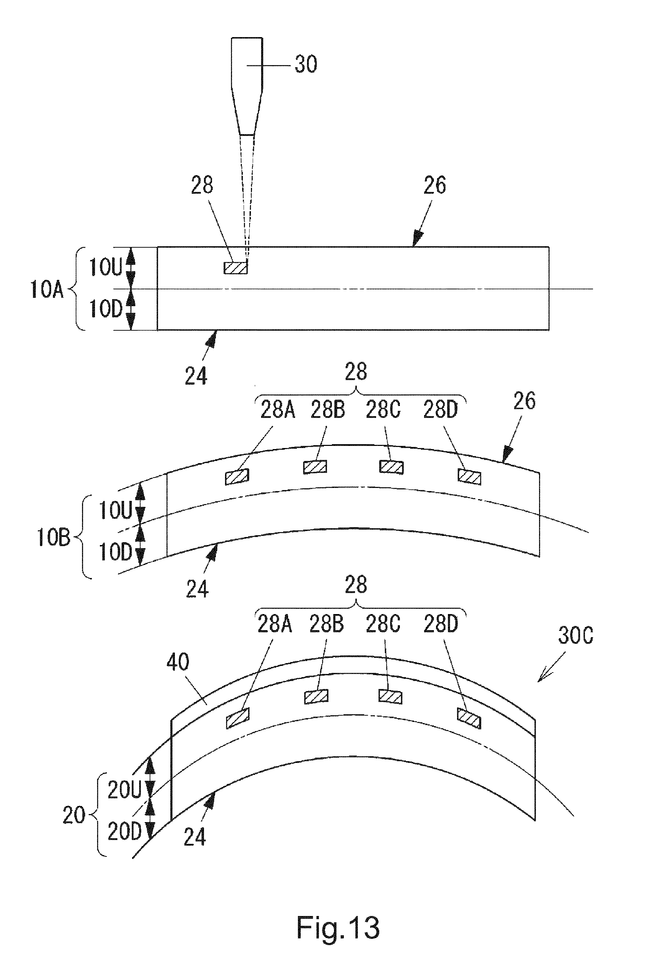

In addition, as illustrated in the upper part of FIG.
13, the conventional single crystal substrate before the step of forming the heat-denatured layer in the second region 10U (single crystal substrate before laser processing 10A) is performed also has no warpage and has a substantially flat shape. In contrast to this, the single crystal substrate according to the another embodiment of the present invention after the heat-denatured layer formation step to the second region 10U (single crystal substrate after laser processing 10B) is performed, which is illustrated in the middle part of FIG. 13, is warped convexly toward the side of the surface of the second region 10U. Of the first region 10D and the second region 10U obtained by bisecting the single crystal substrate after laser processing 10B in the thickness direction thereof along the one-dot chain line, a plurality of heat-denatured layers 28 (28A, 28B, 28C, 28D) having a predetermined thickness are formed in the second region 10U at regular intervals in the planar direction of the single crystal substrate after laser processing 10B. Note that, similarly to the above, in the following description, the single crystal substrate 10 may be used in some cases to refer to both or one of the single crystal substrate before laser processing 10A and the single crystal substrate after laser processing 10B. In addition, the single crystal substrates respectively having the heat-denatured layer 20 or the heat-denatured layer 28 formed therein are collectively referred to as the "single crystal substrate after laser processing 10B" because those single crystal substrates are common in that the laser processing has been subjected and that the side of the surface of the region provided with the heat-denatured layer is warped convexly.

Herein, the heat-denatured layer formation step to the second region 10U is also performed in a state in which the single crystal substrate before laser processing 10A is fixed to the sample stage (not shown). Subsequently, from the surface opposite to the side on which the sample stage of the single crystal substrate before laser processing 10A fixed to the sample stage is disposed, the laser is irradiated by the laser irradiation apparatus 30. At this time, the laser is concentrated onto the internal portion of the region corresponding to the second region 10U, and the laser irradiation apparatus 30 and the single crystal substrate before laser processing 10A are moved relative to each other in the horizontal direction. In this manner, the heat-denatured layer 28 is formed. Through appropriate selection of the movement speed of the laser irradiation apparatus 30 relative to the single crystal substrate before laser processing 10A (scanning speed of the sample stage, for example, when the sample stage is movable) and the pulse rate of the laser, it is possible to control the intervals among the individual heat-denatured layers 28A, 28B, 28C, and 28D in the planar direction of the single crystal substrate after laser processing 10B.

### -Warpage of single crystal substrate with multilayer film after multilayer film formation step is performed-

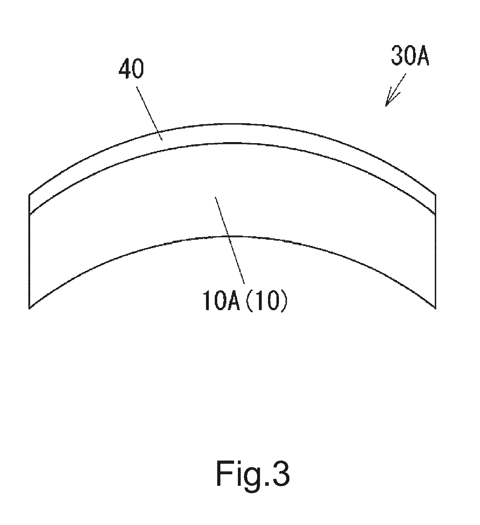

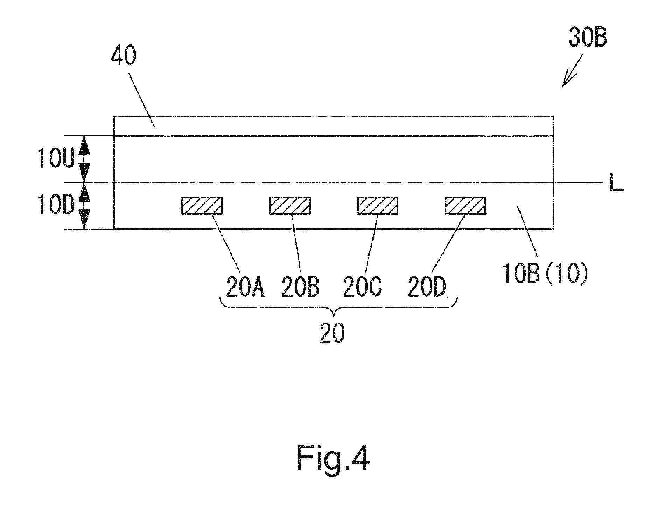

Next, description is given of an example of a warpage state of the single crystal substrate with a multilayer film obtained after forming the multilayer film on the single crystal substrate after laser processing 10B according to this embodiment, which is warped, in contrast to a warpage state of the single crystal substrate with a multilayer film obtained after forming the multilayer film on the conventional substantially flat single crystal substrate before laser processing 10A, which is not warped. FIG. 3 is a schematic cross-sectional view illustrating an example of the warpage state of the single crystal substrate with a multilayer film obtained after forming the multilayer film on the conventional substantially flat single crystal substrate without the warpage. FIG. 4 is a schematic cross-sectional view illustrating the example of the warpage state of the single crystal substrate with a multilayer film obtained after forming the multilayer film on the single crystal substrate according to this embodiment. Note that, in FIGS. 3 and 4, components having the same functions and structures as those of the components illustrated in FIGS. 1 and 2 are represented by the same reference symbols. In addition, in FIGS. 3 and 4, each layer constituting the multilayer film is omitted.

A single crystal substrate with a multilayer film 30A illustrated in FIG. 3 includes the single crystal substrate before laser processing 10A that is substantially flat and does not have the warpage in a state before the film formation as illustrated in the upper part of FIG. 1, and a multilayer film 40 provided on one surface of the single crystal substrate before laser processing 10A. As illustrated in FIG. 3, the single crystal substrate with a multilayer film 30A is significantly warped convexly toward the side of the surface provided with the multilayer film 40.

In contrast to this, a single crystal substrate with a multilayer film 30B illustrated in FIG. 4 includes the single crystal substrate after laser processing 10B that is significantly warped convexly toward the side of the surface of the first region 10D in a state before the film formation as illustrated in the lower part of FIG. 1, and the multilayer film 40 provided on the surface of the side of the second region 10U of the single crystal substrate after laser processing 10B. The single crystal substrate with a multilayer film 30B in which the heat-denatured layer 20 is present is in a substantially flat state without the warpage.

Further, a single crystal substrate with a multilayer film 30C illustrated in the lower part of FIG. 13 includes the single crystal substrate before laser processing 10A that is substantially flat and does not have the warpage in a state before the film formation as illustrated in the upper part of FIG. 13, and a multilayer film 40 provided on one surface of the single crystal substrate before laser processing 10A. As illustrated in the lower part of FIG. 13, the single crystal substrate with a multilayer film 30C is significantly warped convexly toward the side of the surface provided with the multilayer film 40.

A single crystal substrate with a multilayer film 30C illustrated in the lower part of FIG. 13 includes the single crystal substrate after laser processing 10B that is significantly warped convexly toward the side of the surface of the second region 10U in a state before the film formation as illustrated in the middle part of FIG. 13, and the multilayer film 40 provided on the surface of the side of the second region 10U of the single crystal substrate after laser processing 10B. The single crystal substrate with a multilayer film 30A in which the heat-denatured layer 28 is present is warped convexly toward the side of the surface of the second region 10U.

### -Disposition pattern of heat-denatured layer-

As illustrated in FIGS. 3 and 4, when the multilayer film 40 is formed by using the single crystal substrate after laser processing 10B provided with the heat-denatured layer 20 in the first region 10D, it is possible to correct the warpage of the single crystal substrate with a multilayer film 30B. However, when the heat-denatured layer 20 is provided at a deviated position, irregularly disposed, or asymmetrically disposed in the thickness direction or the planar direction of the single crystal substrate after laser processing 10B, there are cases where it becomes difficult to correct the warpage resulting from the multilayer film 40, or the shape of the substrate with a multilayer film 30B is distorted.

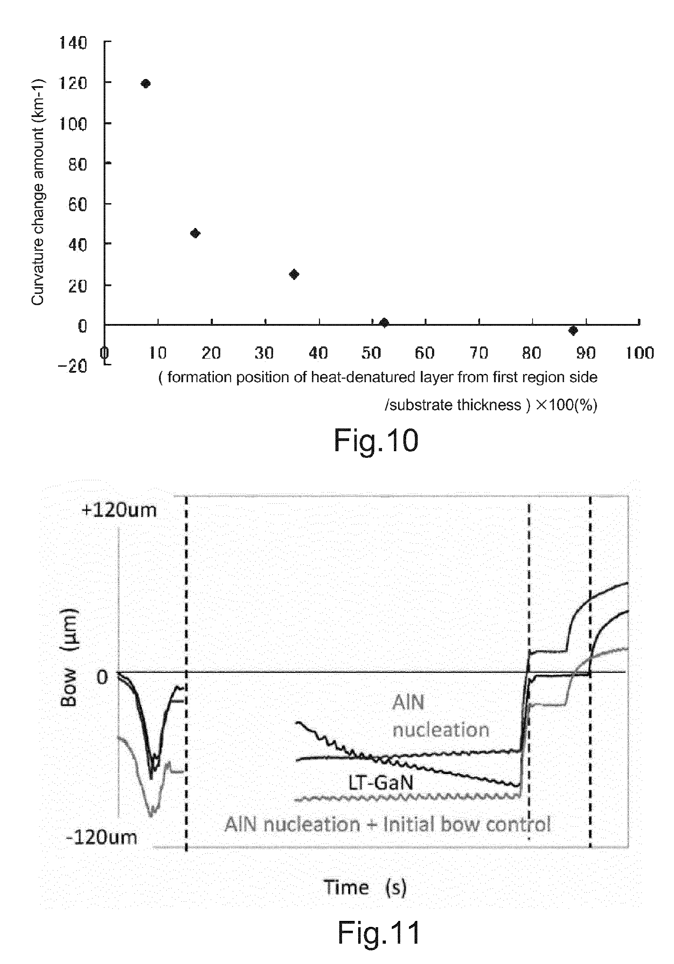

In order to avoid the occurrence of the above-mentioned problem, in the thickness direction of the single crystal substrate after laser processing 10B, the heat-denatured layer 20 is preferably provided in parallel to the multilayer film 40. Note that, in this
case, as shown in FIG. 10, when the relative position of the heat-denatured layer 20 in the thickness direction of the single crystal substrate after laser processing 10B is assumed to be 0% at the surface on the side of the first region 10D and 100% at the surface on the side of the second region 10U, the heat-denatured layer 20 is preferably provided in a range of 5% or more and less than 50% in the thickness direction of the single crystal substrate after laser processing 10B, and more preferably in a range of 5% or more and 30% or less. With provision of the heat-denatured layer 20 in the ranges of values described above in the thickness direction of the single crystal substrate after laser processing 10B, it is possible to more effectively correct the warpage of the single crystal substrate after laser processing 10B resulting from the multilayer film 40, and also suppress the deformation of the single crystal substrate with a multilayer film 30B. Note that, in FIG. 10, the curvature change amount in which the substrate is warped convexly toward the surface on the side of the first region as illustrated in the lower part of FIG. 1 is represented by a + (positive) sign, while the curvature change amount in which the substrate is warped concavely with respect to the surface on the side of the first region is represented by a - (negative) sign. The laser irradiation to the single crystal substrate before laser processing 10A at the time of the laser processing is preferably performed from the surface on the side of the first region 10D as illustrated in FIG. 2. FIG. 10 is a graph showing the depth of the heat-denatured layer and the curvature change amount in the single crystal substrate after laser processing 10B on which the laser irradiation is performed from the surface on the side of the first region 10D. The advantage of performing the laser irradiation from the surface on the side of the first region includes the following point, in addition to the advantage that the absorption loss of the laser light can be suppressed as described above. That is, as shown in FIG. 10, in a case where the heat-denatured layer 20 is formed in the range of 5% or more and less than 50% in the thickness direction of the single crystal substrate after laser processing 10B, it can be seen that, when the laser irradiation is performed from the surface on the side of the first region, the curvature change amount of the single crystal substrate after laser processing 10B is increased. On the other hand, in a case where the heat-denatured layer is formed in the range of more than 50% and 95% or less in the thickness direction of the single crystal substrate after laser processing 10B, it can be seen that, when the laser irradiation is performed from the surface on the side of the first region, the curvature change amount can still be obtained but its magnitude as an absolute value is extremely small. Therefore, in a case where it is desired to set a large warpage amount of the single crystal substrate after laser processing 10B before the formation of the multilayer film while suppressing the number of heat-denatured layers 20 to be formed, it is preferable to perform the laser irradiation from the surface on the side of the first region.

Note that, regarding the position of presence of the heat-denatured layer 20 in the thickness direction of the single crystal substrate after laser processing 10B, the individual heat-denatured layers 20A, 20B, 20C, and 20D are preferably present all at the same position, but the individual heat-denatured layers may also be present at different positions. In this case, the individual heat-denatured layers 20A, 20B, 20C, and 20D may be disposed at different positions in the thickness direction of the single crystal substrate after laser processing 10B so that, also in view of the disposition positions of the individual heat-denatured layers 20A, 20B, 20C, and 20D in the planar direction of the substrate, the shape of the single crystal substrate with a multilayer film 30B is not distorted or the effect of correcting the warpage resulting from providing the heat-denatured layer 20 is not significantly reduced. In addition, the length of the heat-denatured layer 20 in the thickness direction of the single crystal substrate after laser processing 10B is determined depending on the spot size, the irradiation energy (laser power/pulse rate), and the pulse width of the laser, and is usually in a range of several micrometers to several tens of micrometers.

In order to avoid the occurrence of the above-mentioned problems, in the planar direction of the single crystal substrate after laser processing 10B, the heat-denatured layer 20 is preferably provided to have the following pattern shapes. That is, it is preferred that, in the planar direction of the single crystal substrate after laser processing 10B, the heat-denatured layer 20 be provided to have at least one pattern shape selected from the following shapes i) to vii). In this case, the warpage of the single crystal substrate with a multilayer film 30B resulting from the multilayer film 40 can be corrected more effectively to suppress the distortion thereof as well.
i) a shape in which a plurality of polygons identical in shape and size are regularly disposed;
ii) a shape in which a plurality of circles or ellipses identical in shape and size are regularly disposed;
iii) a concentric shape;
iv) a shape formed so as to be substantially point-symmetric with respect to a center point of the single crystal substrate;
v) a shape formed so as to be substantially linearly symmetric with respect to a straight line passing through the center point of the single crystal substrate;
vi) a stripe shape; and
vii) a spiral shape.

Note that, among the pattern shapes i) to vii) described above, from the viewpoint that it is possible to more uniformly correct the warpage of the single crystal substrate with a multilayer film 30B resulting from the multilayer film 40 and further reduce the distortion of the shape, the pattern shapes i) to iv) are more preferable.

In addition, when the heat-denatured layer 20 is formed, from the viewpoint that laser scanning, that is, the movement of the laser irradiation apparatus 30 relative to the single crystal substrate before laser processing 10A is relatively simple as compared with other pattern shapes so as to facilitate the laser process, the pattern shape is preferably i) the shape in which the plurality of polygons identical in shape and size are regularly disposed. Further, as i) the shape in which the plurality of polygons identical in shape and size are regularly disposed, a shape in which a plurality of quadrangles identical in shape and size are regularly disposed so that four sides constituting each quadrangle coincide with any one of four sides of an adjacent quadrangle, that is, a lattice shape is especially preferable. In this case, it is only necessary to perform the laser scanning in vertical and lateral directions. Thus, the laser process can be further facilitated, and the designing of the warpage amount control and the shape control of the single crystal substrate with a multilayer film 30B can also be further facilitated.

Herein, the pitch between the lines constituting the pattern forming the lattice shape is preferably in a range of 50 µm to 2,000 µm, and more preferably in a range of 100 µm to 1,000 µm. With the setting of the pitch to 50 µm or more, it is possible to suppress an unnecessary increase in time period required for the laser process and, with the setting of the pitch to 2,000 µm or less, it is possible to more reliably correct the warpage of the single crystal substrate with a multilayer film 30B resulting from the multilayer film 40.

FIGS. 5 are plan views illustrating examples of the disposition pattern shape of the heat-denatured layer in the planar direction of the substrate. Specifically, FIGS. 5 illustrate examples of the disposition pattern shape of the heat-denatured layer 20 when the planar shape of the single crystal substrate after laser processing 10B is the circular shape having the orientation flat plane. As illustrated in FIGS. 5, examples of the disposition pattern shape of the heat-denatured layer 20 include stripe shapes (FIGS. 5A and 5B) in which a plurality of lines are formed perpendicular to or in parallel to the orientation flat plane of the substrate, and a lattice shape (FIG. 5C) obtained by combining the above-mentioned stripe shapes. In addition, other examples of the disposition pattern shape include a shape (FIG. 5D) in which a plurality of regular hexagons identical in size are regularly disposed so that each of six vertices of each regular hexagon always coincides with any one of vertices of an adjacent regular hexagon, and a concentric shape (FIG. 5E). Note that, a width W illustrated in FIG. 5A denotes the pitch between lines.

Note that, in the example illustrated in FIG. 4, there may be a case where the single crystal substrate with a multilayer film 30B is warped convexly toward the side of one of the surfaces thereof. However, in either case, the warpage illustrated in FIG. 3 is corrected so that the direction of the warpage remains unchanged and the warpage amount is suppressed, or the warpage is corrected so that the direction of the warpage is reversed. That is, the degree of the warpage resulting from the multilayer film 40 varies depending on the layer structure and the film thickness of the multilayer film 40 and the thickness and the material of the single crystal substrate after laser processing 10B. However, through appropriate selection and combination, in accordance with the degree of the warpage, of the above-mentioned i) length of the heat-denatured layer 20 in the thickness direction of the single crystal substrate after laser processing 10B, ii) disposition position of the heat-denatured layer 20 in the thickness direction of the single crystal substrate after laser processing 10B, and iii) disposition pattern shape of the heat-denatured layer 20 in the planar direction of the single crystal substrate after laser processing 10B, regarding the single crystal substrate with a multilayer film 30A, it is possible to not only correct the warpage resulting from the multilayer film 40 of the single crystal substrate with a multilayer film 30B but also form the single crystal substrate with a multilayer film 30B into a substantially flat shape. Note that, from the viewpoint that an adverse effect in the subsequent step resulting from the warpage can be reduced, the curvature of the single crystal substrate with a multilayer film 30B is preferably in a range of ±30 km⁻¹ and more preferably in a range of ±20 km⁻¹.

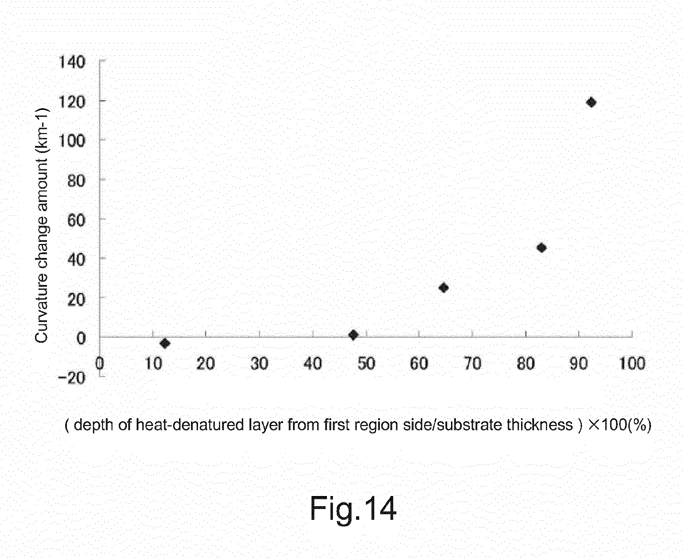

In addition, in a case where the heat-denatured layer 28 is provided in the second region 10U, in the thickness direction of the single crystal substrate after laser processing 10B, the
heat-denatured layer 28 is preferably provided in parallel to the multilayer film 40. Note that, in this case, when the relative position of the heat-denatured layer 28 in the thickness direction of the single crystal substrate after laser processing 10B is assumed to be 0% at the surface on the side of the first region 10D and 100% at the surface on the side of the second region 10U, the heat-denatured layer 28 is preferably provided in a range of more than 50% and 95% or less in the thickness direction of the single crystal substrate after laser processing 10B. Further, the heat-denatured layer 28 is more preferably provided in a range of 80% or more and 95% or less. With provision of the heat-denatured layer 28 in the ranges of values described above, it is possible to reduce the warpage of the single crystal substrate 10B at an arbitrary film formation stage during the formation of the multilayer film 40 to 0, and also suppress the deformation of the single crystal substrate with a multilayer film 30A. Note that, in FIG. 14, the curvature change amount in which the substrate is warped convexly toward the surface on the side of the second region 10U as illustrated in the middle part of FIG. 13 is represented by a + (positive) sign, while the curvature change amount in which the substrate is warped concavely with respect to the surface on the side of the second region 10U is represented by a - (negative) sign. The laser irradiation to the single crystal substrate before laser processing 10A at the time of the laser processing is preferably performed from the surface on the side of the second region 10U as illustrated
in the upper part of FIG. 13. FIG. 14 is a graph showing the depth of the heat-denatured layer and the curvature change amount in the single crystal substrate after laser processing 10B on which the laser irradiation is performed from the surface on the side of the second region. The advantage of performing the laser irradiation from the surface on the side of the second region includes the following point, in addition to the advantage that the absorption loss of the laser light can be suppressed as described above. That is, as shown in FIG. 14, in a case where the heat-denatured layer 28 is formed in the range of more than 50% to 95% or less in the thickness direction of the single crystal substrate after laser processing 10B, it can be seen that, when the laser irradiation is performed from the surface on the side of the second region, the curvature change amount of the single crystal substrate after laser processing 10B is increased. On the other hand, in a case where the heat-denatured layer is formed in the range of 0% or less to less than 50% in the thickness direction of the single crystal substrate after laser processing 10B, it can be seen that, when the laser irradiation is performed from the surface on the side of the second region, the curvature change amount can still be obtained but its magnitude as an absolute value is extremely small. Therefore, in a case where it is desired to set a large warpage amount of the single crystal substrate after laser processing 10B before the formation of the multilayer film while suppressing the number of heat-denatured layers 28 to be formed, it is preferable to perform the laser irradiation from the surface on the side of the second region.

Note that, regarding the position of presence of the heat-denatured layer 28 in the thickness direction of the single crystal substrate after laser processing 10B, the individual heat-denatured layers 28A, 28B, 28C, and 28D are preferably present all at the same position, but the individual heat-denatured layers may also be present at different positions. In this case, the individual heat-denatured layers 28A, 28B, 28C, and 28D may be disposed at different positions in the thickness direction of the single crystal substrate after laser processing 10B so that, also in view of the disposition positions of the individual heat-denatured layers 28A, 28B, 28C, and 28D, the shape of the single crystal substrate with a multilayer film 30C is not distorted or the effect of providing the heat-denatured layer 28 is not significantly reduced. In addition, the length of the heat-denatured layer 28 in the thickness direction of the single crystal substrate after laser processing 10B is determined depending on the spot size, the irradiation energy (laser power/pulse rate), and the pulse width of the laser, and is usually in a range of several micrometers to several tens of micrometers.

Further, in the planar direction of the single crystal substrate after laser processing 10B, the heat-denatured layer 28 is preferably provided to have at least one pattern shape selected from the following shapes i) to vii) similarly to the heat-denatured layer 20:
i) a shape in which a plurality of polygons identical in shape and size are regularly disposed;
ii) a shape in which a plurality of circles or ellipses identical in shape and size are regularly disposed;
iii) a concentric shape;
iv) a shape formed so as to be substantially point-symmetric with respect to a center point of the single crystal substrate;
v) a shape formed so as to be substantially linearly symmetric with respect to a straight line passing through the center point of the single crystal substrate;
vi) a stripe shape; and
vii) a spiral shape.

Note that, among the pattern shapes i) to vii) described above, from the viewpoint that it is possible to more uniformly correct the warpage of the single crystal substrate with a multilayer film 30A resulting from the multilayer film 40 and further reduce the distortion of the shape, the pattern shapes i) to iv) are more preferable.

In addition, when the heat-denatured layer 28 is formed, from the viewpoint that laser scanning, that is, the movement of the laser irradiation apparatus 40 relative to the single crystal substrate before laser processing 10A is relatively simple as compared with other pattern shapes so as to facilitate the laser process, the pattern shape is preferably i) the shape in which the plurality of polygons identical in shape and size are regularly disposed. Further, as i) the shape in which the plurality of polygons identical in shape and size are regularly disposed, a shape in which a plurality of quadrangles identical in shape and size are regularly disposed so that four sides constituting each quadrangle coincide with any one of four sides of an adjacent quadrangle, that is, a lattice shape is especially preferable. In this case, it is only necessary to perform the laser scanning in vertical and lateral directions. Thus, the laser process can be further facilitated, and the designing of the warpage amount control and the shape control of the single crystal substrate with a multilayer film 30C can also be further facilitated.

Herein, the pitch between the lines constituting the pattern forming the lattice shape is preferably in a range of 50 µm to 2,000 µm, and more preferably in a range of 100 µm to 1,000 µm. With the setting of the pitch to 50 µm or more, it is possible to suppress an unnecessary increase in time period required for the laser process and, with the setting of the pitch to 2,000 µm or less, it is possible to more effectively realize the setting of the warpage of the single crystal substrate after laser processing 10B to 0 at an arbitrary film formation stage during the film formation of the multilayer film 40.

The disposition pattern shape of the heat-denatured layer 28 includes various shapes illustrated in FIGS. 5. Note that, a width W illustrated in FIG. 5A corresponds to a pitch between lines.

Note that, through appropriate selection and combination, in accordance with the degree of the warpage resulting from the multilayer film 40, of i) the length of the heat-denatured layer 28 in the thickness direction of the single crystal substrate after laser processing 10B, ii) the disposition position of the heat-denatured layer 28 in the thickness direction of the single crystal substrate after laser processing 10B, and iii) the disposition pattern shape of the heat-denatured layer 28 in the planar direction of the single crystal substrate after laser processing 10B, it is possible to not only correct the warpage resulting from the multilayer film 40 of the single crystal substrate with a multilayer film 30C but also reduce the warpage of the single crystal substrate 10B at an arbitrary film formation stage during the formation of the multilayer film to 0.

### -Curvature of single crystal substrate after laser processing-

On the other hand, as illustrated in the lower part of FIG. 1, as long as the single crystal substrate after laser processing 10B is warped convexly toward the surface on the side of the first region 10D, the curvature thereof is not particularly limited. However, the upper limit value of the curvature thereof is preferably 200 km⁻¹ or less, more preferably 150 km⁻¹ or less, and further preferably 60 km⁻¹ or less. In this case, it becomes easy to suppress the warpage of, and hence further flatten, the single crystal substrate with a multilayer film 30B obtained by forming the multilayer film 40.

Table 2 shows examples of the curvature of the warpage of the single crystal substrate after laser processing and examples of the embodiment in which the curvature of the warpage is 200 km⁻¹ or less. From Table 2, each single crystal substrate before laser processing (before being processed) had a curvature of 10 km⁻¹ or 11 km⁻¹, and had a concave shape. That is, the heat-denatured layer was provided in the first region, the side of the substrate surface of the first region was convex, and the side of the substrate surface of the other region was concave. It was found that, with provision of the heat-denatured layer 20 at a process pitch of 100 µm or more in the single crystal substrate before laser processing (before being processed), it was possible to control the curvature of the single crystal substrate after laser processing (after being processed) to be 200 km⁻¹ or less. In addition, it was found that, even with the same process pitch, through formation of the heat-denatured layer at a position closer to the side of the first region than to the side of the second region in the thickness direction of the single crystal substrate, the curvature of the single crystal substrate was further increased. Further, it was found that, even when the heat-denatured layer was formed at the same position in the thickness direction of the single crystal substrate, the curvature of the single crystal substrate having a smaller process pitch was larger than that of the single crystal substrate having a larger process pitch.

**[Table 2]**

| Sample No. | Before film formation | | | | | |
|---|---|---|---|---|---|---|
| | Formation position of heat-denatured layer from first region side (µm) | Process pitch (µm) | Before being processed | | After being processed | |
| | | | Curvature (km⁻¹) | Shape | Curvature (km⁻¹) | Shape |
| 1 | 50 | 100 | 10 | Concave | 200 | Convex |
| 2 | 200 | 100 | 10 | Concave | 46 | Convex |
| 3 | 200 | 1, 000 | 11 | Concave | 5 | Convex |

In addition, as illustrated in the middle part of FIG. 13, when the single crystal substrate after laser processing 10B after the heat-denatured layer 28 is formed in the second region 10U by the laser processing is warped convexly toward the surface on the side of the second region 10U, the curvature thereof is not particularly limited. However, the upper limit value of the curvature is preferably 200 km⁻¹ or less, more preferably 150 km⁻¹ or less, and further preferably 60 km⁻¹ or less. In this case, the warpage of the single crystal substrate with a multilayer film 30C obtained by forming the multilayer film 40 is suppressed, and it becomes easier to reduce the warpage of the single crystal substrate after laser processing 10B at an arbitrary film formation stage during the formation of the polycrystalline film 40 to 0.

### -Single crystal substrate-

As a material constituting the single crystal substrate before laser processing 10A to be used in the production of the single crystal substrate after laser processing 10B, there can be used any known single crystal material capable of forming the heat-denatured layers 20 and 28 by laser irradiation. Examples of the material include sapphire, nitride semiconductor, Si, GaAs, crystal, and SiC. Note that, the single crystal substrate with a multilayer film according to this embodiment uses a single crystal substrate made of a single crystal material. However, even when a substrate made of a polycrystalline material (for example, a quartz substrate) or a substrate made of a non-crystalline material (for example, a glass substrate) is used instead of the above-mentioned substrate, it is also possible to obtain a flat substrate with a multilayer film in which the occurrence of the warpage resulting from the multilayer film is corrected.

In addition, as the single crystal substrate before laser processing 10A, a single crystal substrate having at least one mirror-polished surface is usually used, and a single crystal substrate having both surfaces which are mirror-polished may also be used. In a case where only one surface is mirror-polished, the single crystal substrate after laser processing 10B is usually produced by performing the laser irradiation from the side of this surface, and then the multilayer film 40 is formed after the surface on the side of the second region 10U is mirror-polished. Further, as the single crystal substrate before laser processing 10A to be used in the production of the single crystal substrate after laser processing 10B, from the viewpoint of ease of production and availability of a substrate, there is used a substrate in which no heat-denatured layer is formed by the laser process or no composition denatured layer is formed by ion implantation, and which usually has the warpage amount of approximately 0, that is, is substantially flat, in a state in which no film is formed.

The shape of the single crystal substrate 10 in the planar direction is not particularly limited, and the shape thereof may be, for example, a square or the like. However, from the viewpoint of easy application to the manufacturing lines for various known elements, a circular shape is preferable, and a circular shape provided with an orientation flat plane is especially preferable.

When the single crystal substrate 10 has the circular shape or the circular shape provided with the orientation flat plane, the diameter of the single crystal substrate 10 is preferably 50 mm or more, more preferably 75 mm or more, and further preferably 100 mm or more. In a case where the diameter is set to 50 mm or more, when the single crystal substrate with a multilayer film 30A is produced by forming the multilayer film 40 by using the single crystal substrate before laser processing 10A, as the diameter is increased, a difference in height (warpage amount) is increased between the vicinity of the central portion of the single crystal substrate with a multilayer film 30A and the vicinity of the end portion thereof in the vertical direction when the single crystal substrate with a multilayer film 30A is assumed to be placed on a flat surface. However, when the single crystal substrate with a multilayer film 30B or 30C is produced by forming the multilayer film 40 by using the single crystal substrate after laser processing 10B, it is possible to correct such large warpage and easily reduce the warpage amount, and hence it is possible to reduce an adverse effect on the subsequent step. Note that, the upper limit value of the diameter is not particularly limited but, from the viewpoint of practicality, is preferably 300 mm or less.

In addition, the thickness of the single crystal substrate 10 is preferably 5.0 mm or less, preferably 3.0 mm or less, and more preferably 2.0 mm or less. In a case where the thickness thereof is set to 5.0 mm or less, the thickness is small, and hence the rigidity of the single crystal substrate after laser processing 10B is reduced and the single crystal substrate after laser processing 10B becomes likely to be deformed. In this case, in the single crystal substrate with a multilayer film 30A obtained by forming the multilayer film 40 by using the single crystal substrate before laser processing 10A, the warpage amount becomes likely to be increased. However, in a case where the multilayer film 40 is formed by using the single crystal substrate after laser processing 10B, the warpage amount of the single crystal substrate after laser processing 10B may be adjusted in consideration of an increase in warpage that occurs when the above-mentioned single crystal substrate before laser processing 10A is used. In this manner, the warpage amount of the single crystal substrate with a multilayer film 30B to be produced can be easily controlled to be in the vicinity of 0. Alternatively, the warpage of the single crystal substrate 30C at an arbitrary film formation stage during the formation of the multilayer film can be set to 0. Therefore, it is possible to reduce an adverse effect on the subsequent step even when the diameter of the single crystal substrate 10 is increased. Further, because of the circumstances described above, when it is necessary in the subsequent step to polish the single crystal substrate after laser processing 10B to a predetermined thickness by polishing on the surface of the side of the first region 10D of the single crystal substrate with a multilayer film 30B or 30C, it is possible to form the multilayer film 40 by using the single crystal substrate after laser processing 10B having a smaller thickness so that a polishing allowance is further reduced in such a range that the adverse effect on the subsequent step is not increased. In this case, it is possible to reduce a time period required for polishing in the subsequent step, to thereby improve productivity in the subsequent step.

The lower limit value of the thickness is not particularly limited but, in view of securing a region where the heat-denatured layer 20 or 28 can be formed, is preferably 0.05 mm or more and preferably 0.1 mm or more. In a case where the single crystal substrate 10 has the circular shape or the circular shape provided with the orientation flat plane, when the diameter is 50 mm or more and 100 mm or less, the thickness is preferably 0.3 mm or more and, when the diameter is more than 100 mm, the thickness is preferably 0.5 mm or more.

### -Multilayer film-

In the description of this application, the "multilayer film" refers to a film including two or more layers. In addition to this, the "multilayer film" means a film in which each layer constituting the multilayer film does not have a stepped portion extending through a film of the uppermost layer formed of continuous layers identical in film thickness in the planar direction of the single crystal substrate. The layer structure of the multilayer film 40, and the film thickness, the material, and the crystallinity/non-crystallinity of each layer constituting the multilayer film 40 are appropriately selected in accordance with the type of an element to be produced by further performing a subsequent process on the single crystal substrate with a multilayer film 30B or 30C manufactured with use of the single crystal substrate 10B according to this embodiment and in accordance with the manufacturing process used when the element is manufactured.

However, at least one of the layers constituting the multilayer film 40 is preferably a crystalline layer. Further, from the viewpoint that epitaxial growth can be caused by using the crystal plane exposed on the film formation surface of the single crystal substrate after laser processing 10B, among the individual layers constituting the multilayer film 40, at least the layer that directly comes into contact with the film formation surface of the single crystal substrate after laser processing 10B is preferably a crystalline layer, and all of the layers constituting the multilayer film 40 may also be crystalline layers. Note that, epitaxial growth includes homoepitaxial growth and heteroepitaxial growth that include the same composition or a mixed crystal. Furthermore, the material of each layer constituting the multilayer film 40 is also appropriately selected in accordance with the element to be produced. However, in view of that the substrate used for manufacturing the single crystal substrate after laser processing 10B is made of an inorganic material such as a sapphire substrate, the material constituting each layer is preferably an inorganic material such as a metal material, a metal oxide material, or an inorganic semiconductor material, and all layers are desirably made of those inorganic materials. However, when the MOCVD method is used as a film formation method, there is a possibility that a minute amount of organic matter of an organic metal origin is mixed into the inorganic material.

Specific examples of each layer constituting the multilayer film 40 may include, as the layer suitable for the manufacturing of elements using various types of nitride semiconductor such as a light emitting element used in a surface emitting laser or the like, a light receiving element used in an optical sensor or a solar cell, and a semiconductor element used in an electronic circuit or the like, for example, GaN-based, AlGaN-based, and InGaN-based nitride semiconductor crystal layers. In this case, as the substrate used for manufacturing the single crystal substrate after laser processing 10B, it is suitable to use the sapphire substrate. In addition, as a specific example of the layer structure of the multilayer film 40, for example, in a case where a light emitting element using the nitride semiconductor is produced as the element, the sapphire substrate in which the heat-denatured layers 20 and 28 are formed can be used as the single crystal substrate after laser processing 10B, and there can be adopted a layer structure in which, from the side of the sapphire substrate, a buffer layer made of GaN, an n-type contact layer made of n-type GaN, an n-type cladding layer made of n-type AlGaN, an active layer made of n-type InGaN, a p-type cladding layer made of p-type AlGaN, and a p-type contact layer made of p-type GaN are laminated in the stated order.

The film thickness of the multilayer film 40 is appropriately selected depending on the element to be produced. In general, as the film thickness of the multilayer film 40 is increased, the warpage amount of the single crystal substrate with a multilayer film 30A, which is obtained by forming the multilayer film 40 on the single crystal substrate before laser processing 10A, is also increased. Conventionally, the effect on variations in element quality and the yield of the element becomes marked. In addition, in this case, a crack becomes likely to occur in the multilayer film 40 due to a brittle fracture resulting from the warpage after the film formation. However, the multilayer film 40 may be formed by using the single crystal substrate after laser processing 10B that is produced so as to have a predetermined warpage amount through the laser irradiation so that the warpage amount of the single crystal substrate with a multilayer film 30B after the formation of the multilayer film 40 can be controlled to be in the vicinity of 0. In this manner, it is possible to more reliably suppress the occurrence of the above-mentioned problem. Note that, the upper limit of the film thickness of the multilayer film 40 is not particularly limited. In addition, the number of layers of the multilayer film may be any number equal to or more than two, and the number of layers can appropriately be selected depending on the type of the element to be produced.

The film formation method for the multilayer film 40 is not particularly limited, and it is possible to use known film formation methods. It is also possible to adopt a different film formation method and/or a different film formation condition for each of the layers constituting the multilayer film 40 to form the film. Examples of the film formation method include a liquid phase deposition method such as a plating method, but it is preferable to use a vapor phase deposition method such as a sputtering method or a chemical vapor deposition (CVD) method. When a semiconductor crystal layer such as a nitride semiconductor crystal layer is formed for producing a light emitting element or the like, it is more preferable to use the vapor phase deposition method such as a metal organic chemical vapor deposition (MOCVD) method, a hydride vapor phaseepitaxy (HVPE) method, oramolecularbeamepitaxy (MBE) method. Note that, the surface of the single crystal substrate after laser processing 10B on which the multilayer film 40 is formed is especially preferably in the state of the mirror plane (surface roughness Ra of approximately 1 nm or less). In order to bring the surface on which the multilayer film 40 is formed into the state of the mirror plane, for example, mirror polishing can be performed.

### -Specific example of multilayer film formation step-

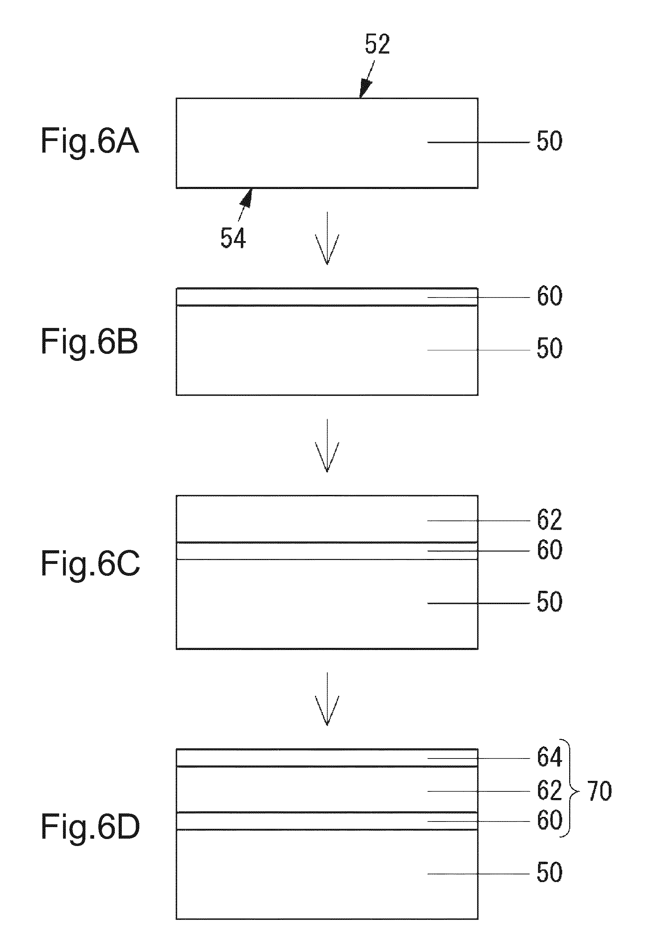

Next, as a specific example of a case where the multilayer film 40 is formed, description is made, with reference to the drawings, of a case where the sapphire substrate in which the heat-denatured layers 20 and 28 are formed by the laser irradiation (sapphire substrate after laser processing) is used as the single crystal substrate after laser processing 10B, and the multilayer film 40 is formed on one surface of the sapphire substrate after laser processing by laminating a plurality of nitride semiconductor layers by epitaxial growth. FIGS. 6 are schematic explanatory diagrams illustrating an example of the multilayer film formation step. Specifically, FIGS. 6 are diagrams illustrating the process of forming the multilayer film by laminating a nitride semiconductor layer and the like on the sapphire substrate. FIG. 6A illustrates a state before the film formation is started. FIG. 6B illustrates a state after a low-temperature buffer layer is formed. FIG. 6C illustrates a state after an n-GaN layer is formed. FIG. 6D illustrates a state after an InGaN-based active layer having a multi-quantum well structure is formed. Note that, in FIGS. 6, illustration is omitted as for the presence or absence of the warpage and the degree of the warpage of the sapphire substrate after laser processing during and after the formation of the multilayer film, the heat-denatured layer 20, the first region 10D, and the second region 10U.

First, thermal cleaning is performed on a surface on the side of the second region 10U (hereinafter referred to as "film formation surface 52") of a sapphire substrate after laser processing 50 (single crystal substrate after laser processing 10B) before the start of the film formation (FIG. 6A). Next, on the film formation surface 52, a low-temperature buffer layer 60 (FIG. 6B), an n-GaN layer 62 (FIG. 6C), and an InGaN-based active layer 64A (GaN-based layer 64) having the multi-quantum well structure (FIG. 6D) are grown in the stated order. With this, a multilayer film 70 (multilayer film 40) formed of three layers is formed on one surface of the sapphire substrate after laser processing 50. After that, by performing a predetermined subsequent step, it is possible to obtain a light emitting element such as an LED chip. Note that, each layer constituting the multilayer film 70 can be formed by using, for example, the MOCVD method, the HVPE method, and the MBE method.

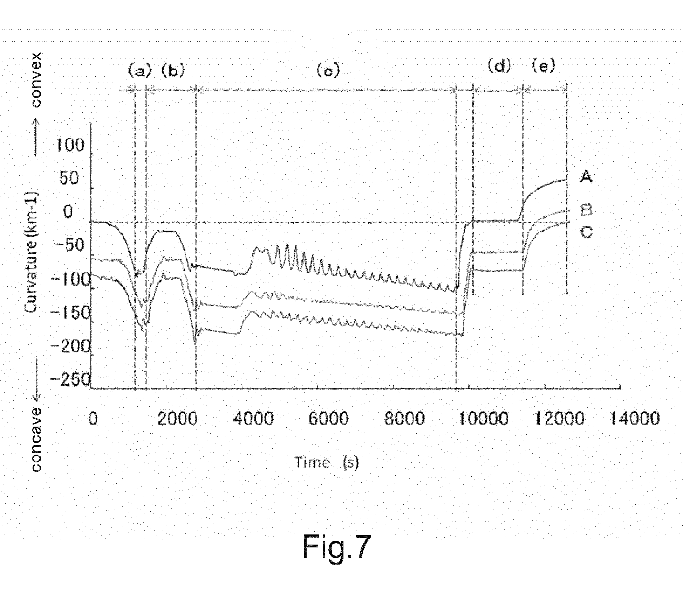

Next, the warpage behavior of the single crystal substrate 10 in the multilayer film formation step is described. FIG. 7 is a graph showing an example of the warpage behavior of the single crystal substrate in the multilayer film formation step. Specifically, FIG. 7 is a graph showing the warpage behavior of the sapphire substrate after laser processing 50 or the sapphire substrate before laser processing during the formation of the multilayer film 70 illustrated in FIGS. 6. Note that, in the description of FIG. 7, the sapphire substrate after laser processing 50 and the sapphire substrate before laser processing are collectively referred to as simply "sapphire substrate". In FIG. 7, the horizontal axis represents time, while the vertical axis represents the curvature of the sapphire substrate at the film formationsurface. Notethat,the positive directionofthe vertical axis represents a state in which the sapphire substrate is convexly warped toward the side of the film formation surface, while the negative direction of the vertical axis represents a state in which the sapphire substrate is concavely warped on the side of the film formation surface. The specification of the sapphire substrate measured for each of Spectrums A to C shown in FIG. 7 and the details of film formation conditions for this sapphire substrate are described in detail in Examples described later.

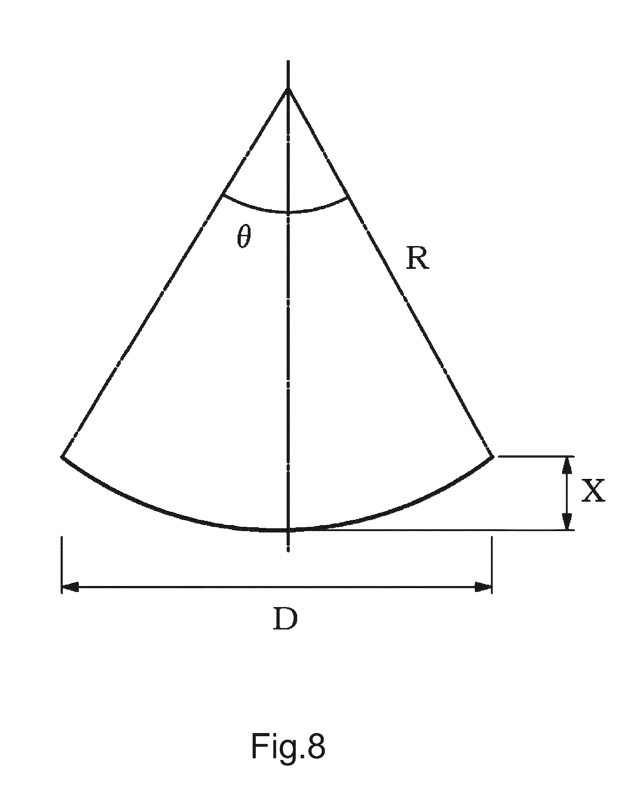

Note that, the warpage behavior of the sapphire substrate during the multilayer film formation step as shown in FIG. 7 can be grasped by using an in-situ observation method disclosed in Non Patent Literature 2. In addition, from the curvature of the substrate represented by the vertical axis of FIG. 7, the warpage amount of the substrate can be calculated. FIG. 8 is a schematic explanatory diagram illustrating a method of calculating the warpage amount of the substrate from the curvature of the circular substrate. In FIG. 8, the curvature radius of the substrate is represented by R, the warpage amount of the substrate having the curvature of 1/R is represented by X, and the approximate diameter of the substrate is represented by D. With use of the Pythagorean theorem for the relationship among those values, (1/R)²=((1/R)-X)²+(D/2)² can be given. Based on this expression, the warpage amount (µm) can be determined by 0.322 × the curvature (km⁻¹) when the diameter of the substrate is 50 mm, and the warpage amount (µm) can be determined by 1.250 × the curvature (km⁻¹) when the diameter of the substrate is 100 mm.

Among three Spectrums representing changes in warpage behavior shown in FIG. 7, Spectrum A represents a change in warpage behavior in a case where the multilayer film 70 is formed by using the conventional sapphire substrate before laser processing in which the heat-denatured layer 20 is not formed. On the other hand, each of Spectrums B and C represents a change in warpage behavior in a case where the multilayer film 70 is formed under the same conditions as those in the measurement of Spectrum A except that the sapphire substrate after laser processing 50 is used instead of the conventional sapphire substrate before laser processing. Note that, a difference between Spectrum B and Spectrum C lies in that only the pitches between lines of the heat-denatured layers 20 each formed to have the lattice pattern in the planar direction of the sapphire substrate after laser processing 50 are different. Herein, the pitch between lines of the sapphire substrate after laser processing 50 used in the measurement of Spectrum B was set to 250 µm, while the pitch between lines of the sapphire substrate after laser processing 50 used in the measurement of Spectrum C was set to 100 µm. That is, the heat-denatured layer 20 having the lattice pattern is formed more densely in the planar direction of the substrate in the sapphire substrate after laser processing 50 used in the measurement of Spectrum C than in the sapphire substrate after laser processing 50 used in the measurement of Spectrum B. As a result, as shown in FIG. 7, the absolute value of the curvature of the substrate before the start of the film formation is also larger in the sapphire substrate after laser processing 50 used in the measurement of Spectrum C than in the sapphire substrate after laser processing 50 used in the measurement of Spectrum B.

In addition, sections indicated as (a) to (e) along the horizontal axis of FIG. 7 correspond to respective processes sequentially performed in the multilayer film formation step. Process (a) corresponds to the process of performing thermal cleaning on the film formation surface of the sapphire substrate. Process (b) corresponds to the process of forming the low-temperature buffer layer 60. Process (c) corresponds to the process of forming the n-GaN layer 62. Process (d) corresponds to the process of forming the InGaN-based active layer 64A (64). Process (e) corresponds to the process of performing cooling down.

Next, the change in the warpage behavior of Spectrum A shown in FIG. 7 is described. First, in (a) the process of thermal cleaning of the film formation surface, the sapphire substrate before laser processing is warped in such a direction that the film formation surface becomes concave (negative side in the vertical axis in FIG. 7) due to a difference in temperature between the film formation surface of the sapphire substrate before laser processing and a non-film formation surface thereof, and hence the curvature greatly changes. Subsequently, in (b) the process of forming the low-temperature buffer layer 60, the temperature of the sapphire substrate before laser processing is reduced to be lower than the temperature during (a) the process of thermal cleaning of the film formation surface 52, and the temperature is usually maintained at about 500°C to 600°C. As a result, the sapphire substrate is warped in such a direction that the film formation surface becomes convex (positive side in the vertical axis in FIG. 7), and the absolute value of the curvature is reduced.

Then, in (c) the process of forming the n-GaN layer 62, the temperature of the sapphire substrate before laser processing is increased to about 1, 000°C again, and the n-GaN layer 62 is formed. In this process, the sapphire substrate before laser processing is warped in such a direction that the film formation surface becomes concave due to a difference in lattice constant between gallium nitride and sapphire, and the absolute value of the curvature is slightly increased.

Next, in (d) the process of forming the InGaN-based active layer 64A (64), the temperature of the sapphire substrate before laser processing is reduced to about 700°C to 800°C, and the InGaN-based active layer 64A (64) is formed. Lastly, in (e) the process of cooling down the sapphire substrate before laser processing on which the multilayer film 70 is formed, the sapphire substrate before laser processing is warped convexly toward the side of the film formation surface due to a difference in thermal expansion coefficient between the multilayer film 70 and the sapphire substrate before laser processing, and the absolute value of the curvature is increased. The state in which the sapphire substrate before laser processing is warped convexly toward the side of the film formation surface is maintained even after the end of the cooling down to the vicinity of room temperature. However, the above-mentioned warpage can be corrected by using the sapphire substrate after laser processing 50 during the formation of the multilayer film 70 and, through optimization of the disposition pattern of the heat-denatured layer 20, the curvature can be set to a value in the vicinity of 0 as shown by Spectrum C. In this case, even when various subsequent steps such as patterning and back lapping processes are performed in order to obtain the light emitting element such as an LED chip, it is possible to reliably suppress variations in quality and a reduction in yield of the light emitting element that result from the warpage.

Herein, when a light emitting element such as an LED chip is manufactured by performing predetermined subsequent processes by using the sapphire substrate after laser processing 50 with the multilayer film 70 illustrated in FIG. 6D, the uniformity of the film thickness of the InGaN-based active layer 64A (64) and of an In composition in the InGaN-based active layer 64A (64) influences the in-surface uniformity of an emission wavelength, and by extension influences the manufacturing yield of the light emitting element. The uniformity of the film thickness of the InGaN-based active layer 64A (64) and of the In composition in the InGaN-based active layer 64A (64) is influenced by the film formation temperature. Consequently, in (d) the process of forming the InGaN-based active layer 64A (64) of FIG. 7, in order to improve the uniformity of the temperature in the surface of the substrate, it is desirable to set the curvature of the sapphire substrate during the film formation as close to 0 as possible. From the circumstances described above, in a case where, as shown as Spectrum A, the multilayer film 70 is formed by using the conventional sapphire substrate, on which the laser processing is not performed, the curvature in Process (d) is maintained in the vicinity of substantially 0 in many cases.

However, when the substrate used for the formation of the multilayer film 70 is changed from the conventional sapphire substrate, on which the laser processing is not performed, to the sapphire substrate after laser processing 50, as shown in Spectrums B and C, the curvature in Process (d) becomes less than 0. Therefore, in a case where the multilayer film 70 is formed by using the sapphire substrate after laser processing 50, while there is an advantage that (1) the adverse effect on the subsequent step can be reduced by suppressing the warpage of the sapphire substrate after laser processing 50 provided with the multilayer film 70 after the film formation, there is also a disadvantage that (2) the uniformity of the temperature in the surface of the substrate is reduced by the increase in the absolute value of the curvature in Process (d) and, as a result, the yield of the light emitting element is reduced. However, as one method for eliminating the disadvantage, in Process (d), it is possible to heat the sapphire substrate after laser processing 50 by utilizing a heater having a curved shape corresponding to the direction and the curvature of the warpage of the sapphire substrate after laser processing 50 in Process (d) (for example, see E. Armour et. al., semiconductor TODAY Compounds & Advanced Silicon, Vol. 4, Issue 3, April/May 2009, "LED growth compatibility between 2", 4" and 6" sapphire"). In this case, even when the formation of the multilayer film 70 is performed by using the sapphire substrate after laser processing 50, the above-mentioned advantage can be obtained while the above-mentioned disadvantage is avoided.

In addition, in Process (c), in each of Spectrums A to C, after 4,000 s, the absolute value of the curvature is increased with the lapse of time. Such change is not desirable because variations in the film quality and film thickness are caused in the film thickness direction of the n-GaN layer 62 as the base layer of the InGaN-based active layer 64A (64). In this case, after Process (a) is performed, it is preferable to form the AlN layer instead of performing Process (b). With this, in Process (c), the absolute value of the curvature is increased with the lapse of time, and the curvature can be maintained at a substantially constant level.

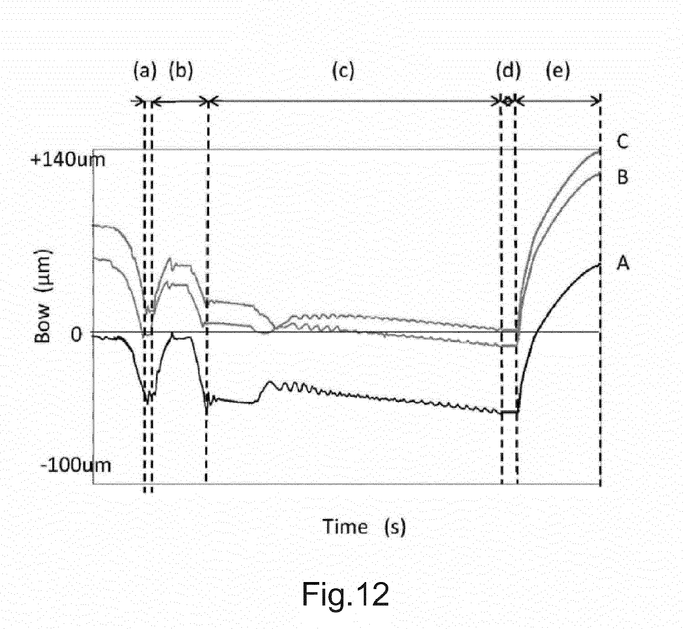

Further, a specific example of a case where the heat-denatured layer 28 is formed in the second region 10U and the multilayer film 40 is formed is as illustrated in FIGS. 6. The warpage behavior of the single crystal substrate 10 in the multilayer film formation step of this case is described. FIG. 12 is a graph showing an example of the warpage behavior of the single crystal substrate in the step of forming the multilayer film on the single crystal substrate in which the heat-denatured layer 28 is formed in the second region. Note that, in the description of FIG. 12, the sapphire substrate after laser processing and the sapphire substrate before laser processing are collectively referred to as simply the "sapphire substrate". Herein, in FIG. 12, the horizontal axis indicates time, while the vertical axis indicates the warpage amount of the sapphire substrate at the film formation surface. Note that, the positive direction of the vertical axis indicates a state in which the sapphire substrate is warped convexly toward the side of the film formation surface, while the negative direction of the vertical axis indicates a state in which the sapphire substrate is warped concavely with respect to the side of the film formation surface. The specification of the sapphire substrate measured for each of Spectrums A to C shown in FIG. 12 and the details of film formation conditions for this sapphire substrate are described in detail in Examples described later.

Note that, the warpage behavior of the sapphire substrate during the multilayer film formation step as shown in FIG. 12 can be grasped by utilizing an in-situ observation method disclosed in Non Patent Literature 2.

Among three Spectrums each representing a change in warpage behavior shown in FIG. 12, Spectrum A represents a change in warpage behavior when the multilayer film 70 is formed by using the conventional sapphire substrate before laser processing in which the heat-denatured layer 28 is not formed. On the other hand, each of Spectrums B and C represents a change in warpage behavior when the multilayer film 70 is formed under the same conditions as those of the measurement of Spectrum A except that the sapphire substrate after laser processing 50 is used instead of the conventional sapphire substrate before laser processing. A difference between Spectrums B and C lies in that only pitches between lines of the heat-denatured layers 28 each formed to have the lattice pattern in the planar direction of the sapphire substrate after laser processing 50 are different. Herein, the pitch between lines of the sapphire substrate after laser processing 50 used in the measurement of Spectrum B was set to 500 µm, while the pitch between lines of the sapphire substrate after laser processing 50 used in the measurement of Spectrum C was set to 300 µm. That is, the heat-denatured layer 28 having the lattice pattern is formed more densely in the planar direction of the substrate in the sapphire substrate after laser processing 50 used in the measurement of Spectrum C than in the sapphire substrate after laser processing 50 used in the measurement of Spectrum B. As a result, as shown in FIG. 12, the absolute value of the warpage amount of the substrate before the start of the film formation is also larger in the sapphire substrate after laser processing 50 used in the measurement of Spectrum C than in the sapphire substrate after laser processing 50 used in the measurement of Spectrum B.

In addition, sections (a) to (e) shown along the horizontal axis of FIG. 12 correspond to respective processes sequentially performed in the multilayer film formation step. Herein, Process (a) corresponds to the process of performing thermal cleaning on the film formation surface of the sapphire substrate, Process (b) corresponds to the process of forming the low-temperature buffer layer 60, Process (c) corresponds to the process of forming the n-GaN layer 62, Process (d) corresponds to the process of forming an arbitrary GaN-based barrier layer 64B (GaN-based layer 64), and Process (e) corresponds to the process of performing cooling down.

Next, the change in warpage behavior of Spectrum A shown in FIG. 12 is described. First, in (a) the process of thermal cleaning of the film formation surface, the sapphire substrate before laser processing is warped concavely with respect to the film formation surface (negative side in the vertical axis in FIG. 12) due to a difference in temperature between the film formation surface of the sapphire substrate before laser processing and the non-film formation surface thereof, and the warpage amount significantly changes. Subsequently, in (b) the process of forming the low-temperature buffer layer 60, the temperature of the sapphire substrate before laser processing is reduced to be lower than the temperature during (a) the process of thermal cleaning of the film formation surface 52, and the temperature is usually maintained at about 500°C to 600°C. As a result, the sapphire substrate before laser processing is warped convexly toward the film formation surface (positive side in the vertical axis in FIG. 12), and the absolute value of the warpage amount is reduced.

Then, in (c) the process of forming the n-GaN layer 62, the temperature of the sapphire substrate before laser processing is increased to about 1, 000°C again, and the n-GaN layer 62 is formed. In this process, the sapphire substrate before laser processing is warped concavely with respect to the film formation surface due to a difference in lattice constant between gallium nitride and sapphire, and the absolute value of the warpage amount is slightly increased.

Next, in (d) the process of forming the arbitrary GaN-based barrier layer 64B (64), the temperature of the sapphire substrate before laser processing is increased to about 1,100°C to 1,200°C, and the GaN-based barrier layer 64B (64) is formed. Then, lastly, in (e) the process of cooling down the sapphire substrate before laser processing on which the multilayer film 70 is formed, the sapphire substrate before laser processing is warped convexly toward the side of the film formation surface due to a difference in thermal expansion coefficient between the multilayer film 70 and the sapphire substrate before laser processing, and the absolute value of the curvature is increased. In addition, the state in which the sapphire substrate before laser processing is warped convexly toward the side of the film formation surface is maintained even after the sapphire substrate before laser processing is cooled down to the vicinity of room temperature and the cooling down is ended.

Herein, in a case where a semiconductor element such as a high electron mobility transistor (HEMT) is manufactured by performing predetermined subsequent processes by using the sapphire substrate after laser processing 50 with the multilayer film 70, the uniformity of the film thickness of the GaN-based barrier layer 64B (64) and of the composition (film quality) in the GaN-based barrier layer 64B (64) influences element performance, and by extension influences the manufacturing yield of the semiconductor element. The uniformity of the film thickness of the GaN-based barrier layer 64B (64) and of the composition in the GaN-based barrier layer 64B (64) is influenced by fluctuations in warpage behavior of the single crystal substrate during the film formation step. Consequently, in (d) the process of forming the GaN-based barrier layer 64B (64) of FIG. 12, in order to suppress the warpage behavior of the substrate, it is desirable to set the curvature of the sapphire substrate during the film formation as close to 0 as possible.

When the substrate used for the formation of the multilayer film 70 is changed from the conventional sapphire substrate, on which the laser processing is not performed, to the sapphire substrate 50 having been subjected to the laser processing on the second region thereof, as shown by Spectrums B and C, the warpage amount in Process (d) becomes 0 or becomes close to 0. Therefore, when the multilayer film 70 is formed by using the sapphire substrate after laser processing 50, there is an effect that it is possible to suppress variations in film thickness and/or film quality of the multilayer film 70.

Note that, the AlN layer may be formed instead of performing Process (b) after Process (a) is performed. With the formation of the AlN layer, it is possible to maintain the warpage amount at a substantially constant level in Process (c).

### (Element manufacturing method)

By performing various subsequent steps on the single crystal substrates with a multilayer film 30B and 30C as exemplified in FIG. 6D, it is possible to produce elements. In this case, in the subsequent step, by performing at least an element portion formation step of performing at least a patterning process on the multilayer film 40 to produce an element portion functioning as any one selected from the group consisting of a light emitting element, a photovoltaic element, and a semiconductor element, it is possible to manufacture an element including the element portion and a single crystal substrate having a size substantially corresponding to the element portion. Here, the layer structure of the multilayer film 40 is appropriately selected in accordance with the type of element to be finallyproduced. In addition, in the manufacturing of the element, besides the element portion formation step, a polishing step, a line-for-division formation step, and a division step may be performed in the stated order as subsequent steps.

In this case, in a manufacturing method for an element using the single crystal substrate with a multilayer film 30B or 30C manufactured by the manufacturing method for a single crystal substrate with a multilayer film according to this embodiment, specifically, by successively performing at least steps (1) to (4) described below, it is possible to produce the element including the element portion and the single crystal substrate having the size substantially corresponding to the element portion.
(1) An element portion formation step of patterning the multilayer film of the single crystal substrate with a multilayer film to form individual element portions.
(2) A polishing step of polishing, at least until the first heat-denatured layer formed in the heat-denatured layer formation step after multilayer film formation is removed, the surface of the single crystal substrate with the element portions on which the element portions are not formed, the single crystal substrate with the element portions having the element portions formed on the one surface thereof.
(3) A line-for-division formation step of applying a laser along a boundary line between the individual element portions from the side of the surface polished in the polishing step to form a line for division.
(4) A division step of applying an external force along the line for division formed in the line-for-division formation step to divide the single crystal substrate with the element portions based on each element portion.
Herein, when (3) the line-for-division formation step and (4) the division step are performed, it is possible to use the technology described in Patent Literature 3.

Note that, when the heat-denatured layer 20 or 28 in the single crystal substrate after laser processing 10B is formed into the lattice pattern, it is theoretically possible to perform the division step by using, after the heat-denatured layer 20 or 28 is polished in the polishing step to such an extent that the heat-denatured layer 20 or 28 is not completely removed, the heat-denatured layer remaining in the single crystal substrate after laser processing 10B as the line for division. However, it is not possible to confirm the positions at which the element portions are present and to perform alignment for the laser irradiation before the multilayer film 40 is individualized into individual element portions. Consequently, in the above-mentioned method in which the heat-denatured layer 20 or 28 functioning also as the line for division is formed before the individual element portions are produced, it is difficult to accurately form the line for division in correspondence to the individual element portions. That is, in the above-mentioned method, the line for division is more prone to be deviated from the boundary line between two adj acent element portions. Thus, the above-mentioned method tends to lack practicality. Consequently, when the division step is performed by using the heat-denatured layer formed by the laser irradiation, it is especially preferable to perform the above-mentioned steps (1) to (4) in this order.

When the line-for-division formation step is performed, as the laser irradiation condition, it is especially desirable to select Irradiation Condition B described above. In the case of Irradiation Condition A in which the laser wavelength is in the ultraviolet region, the laser energy resulting from the laser wavelength is large, and hence the width of the line for division to be formed is large and the width becomes likely to be varied in the length direction of the line. As a result, in the division step, there are cases where it becomes difficult to perform linear and accurate division.

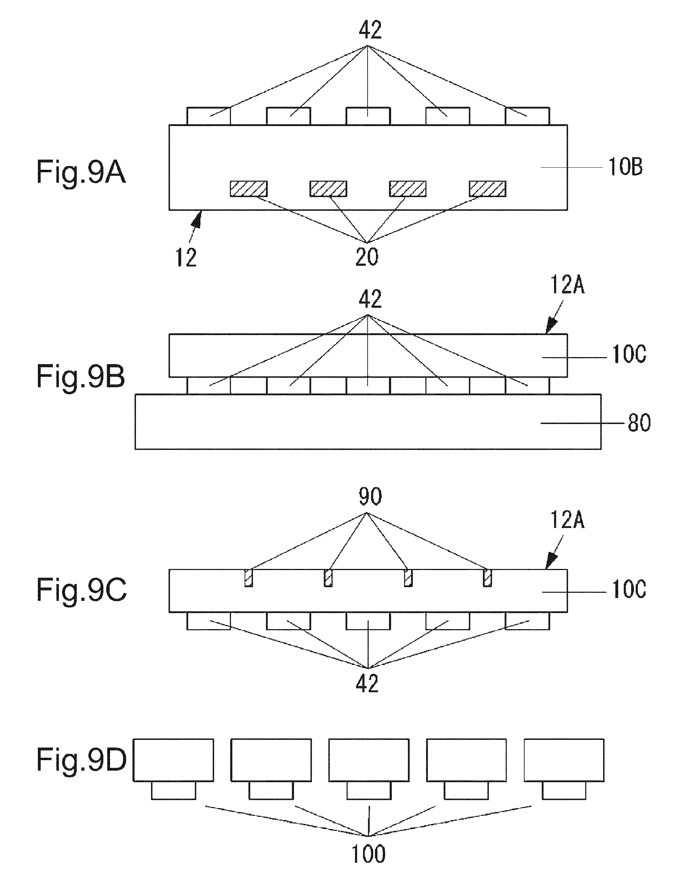

FIGS. 9 are schematic explanatory diagrams illustrating an example of the element manufacturing method according to this embodiment. Specifically, FIGS. 9 illustrate an example of a case where, with use of the single crystal substrate after laser processing 10B illustrated in the lower part of FIG. 1, (1) the element portion formation step (FIG. 9A), (2) the polishing step (FIG. 9B), (3) the line-for-division formation step (FIG. 9C), and (4) the division step (FIG. 9D) are performed in the stated order. Note that, in FIGS. 9, components having the same functions and structures as those illustrated in FIG. 1 or FIG. 13 are represented by the same reference symbols, and illustration is omitted as for the presence or absence and the degree of the warpage of the single crystal substrate after laser processing 10B.

First, by performing the patterning process on the multilayer film 40 formed on the single crystal substrate after laser processing 10B, which is illustrated in the lower part of FIG. 1 or the middle part of FIG. 13, the multilayer film 40 is separated so as to form a plurality of individual element portions 42. Herein, the patterning process may be performed, for example, in the following manner. First, a resist film is formed on the multilayer film 40, patterning is then performed by exposing and developing the resist film using a photomask, and the resist film is partially removed. Thereafter, the multilayer film 40 in the portion from which the resist film is removed is removed by etching, and the element portions 42 are thereby formed (FIG. 9A). Then, through bonding of the surface having the element portions 42 formed thereon and a flat polishing board 80 to each other, the single crystal substrate after laser processing 10B having the element portions 42 formed thereon is fixed onto the polishing board 80, and the side of the surface (non-film formation surface 12) of the single crystal substrate after laser processing 10B opposite to the surface having the element portions 42 formed thereon is polished. When the heat-denatured layer 20 is formed, this polishing is performed until at least the heat-denatured layer 20 is completely removed (FIG. 9B). Note that, when the heat-denatured layer 28 is formed in the second region, the polishing allowance is set arbitrarily. Thereafter, through irradiation of the laser from the side of a non-film formation surface that has been polished 12A, lines for division 90 are formed. Each of the lines for division 90 is formed between two element portions 42 adjacent to each other in the planar direction of a substrate after polishing 10C, which is obtained by polishing the single crystal substrate after laser processing 10B (FIG. 9C). Lastly, through application of an external force along the line for division 90, the substrate after polishing 10C is divided for each element portion 42, and thus a plurality of elements 100 are obtained (FIG. 9D).

### Examples

The present invention is described hereinbelow by using Examples, but the present invention is not limited only to the following Examples.

### <Example 1>

### (Production of sample for evaluation)

By per forming the laser irradiation process on the conventional sapphire substrate on which no pre-process had been performed (sapphire substrate before laser processing), the sapphire substrate after laser processing 50 was produced. Next, as illustrated in FIGS. 6, the multilayer film 70 was formed on each of the sapphire substrate before laser processing and the sapphire substrate after laser processing 50. At this time, evaluation was performed on the warpage amounts and the warpage directions, when viewed from the side of the surface on which the multilayer film was to be formed, before and after the laser irradiation before the formation of the multilayer film, and on the warpage amount and the warpage direction, when viewed from the side of the film formation surface, after the formation of the multilayer film. Hereinbelow, the details of test conditions and evaluation results are described.

### -Sapphire substrate-

As the sapphire substrate before laser processing, a circular sapphire substrate provided with an orientation flat plane (diameter: 4 inches (100 mm), thickness: 650 µm) was used. Note that, the sapphire substrate had both surfaces subjected to mirror-polishing.

### -Formation condition for heat-denatured layer-

First, the sapphire substratebefore laserprocessingwas fixed onto a flat sample stage by vacuum suction. In this state, the heat-denatured layer 20 was formed by performing laser irradiation under the following irradiation conditions from the side of the surface (non-film formation surface 54) of the sapphire substrate before laser processing opposite to the surface on which the sample stage was disposed, and the sapphire substrate after laser processing 50 was obtained. Note that, during the laser irradiation, the sapphire substrate before laser processing was fixed onto the sample stage so that the scanning direction of the sample stage in the vertical direction corresponded to the orientation flat plane of the sapphire substrate before laser processing. Subsequently, the sample stage was scanned relative to the laser irradiation apparatus in the vertical and lateral directions, and the heat-denatured layer 20 was formed so as to have the lattice pattern in the planar direction of the sapphire substrate before laser processing. Then,by changing the scanning speed of the sample stage, a sample in which the pitch between lines constituting the lattice pattern was changed was also produced.
- laser wavelength: 1,045 nm
- pulse width: 500 × 10⁻¹⁵ sec
- pulse rate: 100 kHz
- spot size: 1.6 µm to 3.5 µm
- laser power: 0.3 W
- scanning speed of sample stage: 400 mm/s (appropriately selected depending on the pitch between lines from the range described in the left)

### -Layer structure and film formation condition for multilayer film-

As illustrated in FIGS. 6, the multilayer film 70 including three layers was formed on each of the sapphire substrates before and after laser processing. Note that, the specific film formation conditions were as follows and the processes were performed in the order of (1) to (5) described below.

### (1) Thermal cleaning

After the sapphire substrate was disposed in an MOCVD apparatus, thermal cleaning of the film formation surface was performed for about 120 seconds at a substrate temperature of 1,100°C.

### (2) Formation of low-temperature buffer layer 60

The low-temperature buffer layer 60 (gallium (Ga), nitrogen (N)) was formed to a film thickness of 30 nm at a substrate temperature during the film formation of 530°C and a film formation rate of 0.16 nm/s.

### (3) Formation of n-GaN layer 62

The n-GaN layer 62 was formed to a film thickness of 3,500 nm at a substrate temperature during the film formation of 1,050°C and a film formation rate of 2,000 nm/s.

### (4) Formation of InGaN-based active layer 64A (64)

The InGaN-based active layer 64A (64) was formed to a film thickness of 408 nm at a substrate temperature during the film formation of 750°C and a film formation rate of 10 nm/s.

### (5) Cooling down

The sapphire substrate having one surface on which the low-temperature buffer layer 60, the n-GaN layer 62, and the InGaN-based active layer 64A (64) were formed in the stated order was cooled down to the vicinity of room temperature.

### (Evaluation result)

### -Evaluation of warpage amount and warpage direction-

Table 3 shows the result of evaluation of the warpage amounts and the warpage directions, when viewed from the side of the surface on which the multilayer film was to be formed, before and after the laser irradiation before the formation of the multilayer film, and the warpage amounts and the warpage directions, when viewed from the film formation surface side, after the formation of the multilayer film. Note that, Samples 1 and 2 and Comparative Example correspond to Spectrums C, B, and A shown in FIG. 7, respectively.

As shown in Table 3, in Comparative Example in which the multilayer film 70 was formed by using the sapphire substrate before laser processing, the sapphire substrate was warped convexly toward the side of the film formation surface and the warpage amount was 75 µm. However, in Sample 2 in which the multilayer film 70 was formed by using the sapphire substrate after laser processing, the warpage amount was reduced to 25 µm. In addition, in Sample 1 in which the heat-denatured layer 20 was formed with the pitch between lines set narrower than that of Sample 2, the warpage amount was 0 µm. From these results, it was found that, when the multilayer film 70 was formed by using the sapphire substrate after laser processing 50, it was possible to correct the warpage resulting from the multilayer film 70 and reduce the warpage amount, and even achieve a flat state.

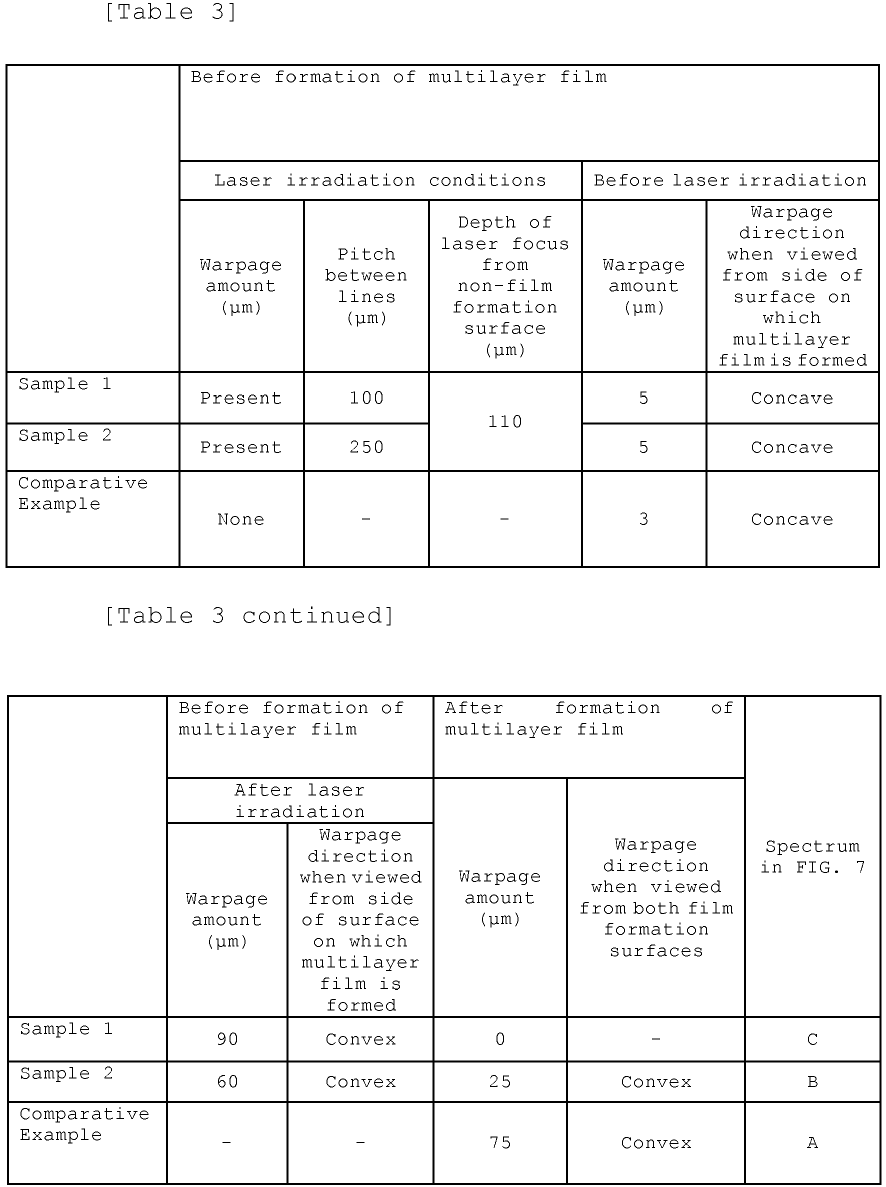

### <Example 2>

### (Production of sample for evaluation)

As a sample for evaluation, a sample in which the multilayer film 70 including three layers was formed on one surface of the sapphire substrate 50 similar to that illustrated in FIG. 6D was produced according to the following procedures. First, the heat-denatured layer 28 was formed so as to have the lattice pattern by the laser irradiation from the side of the film formation surface 52 of the sapphire substrate 50, and the multilayer film 70 was then formed on the film formation surface 52. Thereafter, the heat-denatured layer 20 was formed so as to have the lattice pattern by the laser irradiation from the side of the non-film formation surface 54. In this manner, the sapphire substrate with a multilayer film was produced. At this time, evaluation was performed on the warpage amounts and the warpage directions, when viewed from the film formation surface side, before and after the laser irradiation before the formation of the multilayer film, on the warpage amounts and the warpage directions, when viewed from the film formation surface side, before and after the laser irradiation after the formation of the multilayer film, on the relationship of the change in warpage amount before and after the laser irradiation with respect to the pitch between lines at the time of the laser irradiation after the formation of the multilayer film, and on a difference between maximum and minimum values of the curvature of the sapphire substrate during the formation of the multilayer film. Hereinbelow, the details of test conditions and evaluation results are described.

### -Sapphire substrate-

As the sapphire substrate 50, a circular sapphire substrate provided with an orientation flat plane (diameter: 2 inches (50.8 mm), thickness: 430 µm) was used. Note that, the sapphire substrate 50 had one mirror-polished surface, and the multilayer film 70 was formed by using the mirror-polished surface as the film formation surface 52. In addition, the warpage amount of the sapphire substrate 50 under a state in which no film formation processing or laser irradiation processing was performed was in a range of ±10 µm.

### -Formation condition for heat-denatured layer-

The second heat-denatured layer 28 was formed by performing the laser irradiation from the side of the film formation surface 52 under the following irradiation conditions in a state in which the sapphire substrate 50 was disposed on the flat sample stage so that the film formation surface 52 was positioned as the upper surface and in which the sapphire substrate 50 was fixed by vacuum suction. Note that, during the laser irradiation, the sapphire substrate 50 was fixed onto the sample stage so that the scanning direction of the sample stage in the vertical direction corresponded to the orientation flat plane of the sapphire substrate 50. Subsequently, the sample stage was scanned relative to the laser irradiation apparatus in the vertical and lateral directions, and the first heat-denatured layer 28 was thereby formed so as to have the lattice pattern in the planar direction of the sapphire substrate 50. Herein, the pitch between lines was changed by changing the scanning speed of the sample stage.
- laser wavelength: 1,045 nm
- pulse width: 500 fs
- pulse rate: 100 kHz
- spot size: 1.6 µm to 3.5 µm
- laser power: 0.3 W
- scanning speed of sample stage: 400 mm/s (appropriately selected depending on the pitch between lines within the range mentioned in the left)

### -Layer structure and film formation condition of multilayer film-

The multilayer film 70 including three layers was formed on the film formation surface 52 of the sapphire substrate 50 having the heat-denatured layer 28 formed therein. Specific film formation conditions were as follows, and the processes were performed in the order of (1) to (5) described below.

### (1) Thermal cleaning

After the sapphire substrate 50 was disposed in an MOCVD apparatus, thermal cleaning of the film formation surface 52 was performed for about 120 seconds at a substrate temperature of 1,100 °C.

### (2) Formation of low-temperature buffer layer 60

The low-temperature buffer layer 60 was formed to a film thickness of 30 nmat a substrate temperature during the film formation of 530°C and a film formation rate of 0.16 nm/s.

### (3) Formation of n-GaN layer 62

The n-GaN layer 62 was formed to a film thickness of 3,500 nm at a substrate temperature during the film formation of 1,050°C and a film formation rate of 2,000 nm/s.

### (4) Formation of AlGaN-based barrier layer 64C (GaN-basedlayer 64)

The AlGaN-based barrier layer 64C (64) was formed to a film thickness of 30 nmat a substrate temperature during the film formation of 1,150°C and a film formation rate of 0.2 nm/s.

### (5) Cooling down

The sapphire substrate 50 having one surface on which the low-temperature buffer layer 60, the n-GaN layer 62, and the AlGaN-based barrier layer 64C (64) were formed in the stated order was cooled down to the vicinity of room temperature.

### (Evaluation result)

### -Evaluation of warpage amount and warpage direction-

Table 4 shows the results of evaluation on the warpage amounts and the warpage directions, when viewed from the side of the film formation surface 52, before and after the laser irradiation before the formation of the multilayer film, on the warpage amount and the warpage direction, when viewed from the film formation surface side, during the formation of the multilayer film, and on the warpage amount and the warpage direction, when viewed from the film formation surface side, after the formation of the multilayer film. In addition, FIG. 12 shows changes in warpage behavior of the single crystal substrate during the formation of the multilayer film. In FIG. 12, sections indicated by reference symbols (a) to (e) correspond to the above-mentioned formation processes (1) to (5) of the multilayer film, respectively.

The above-mentioned processes (1) to (5) were sequentially performed on the side of the film formation surface 52 of the single crystal substrate 50 having the heat-denatured layer 28 formed therein. At this time, it was possible to confirm that, during the film formation step for the AlGaN-based barrier layer 64C (64) indicated by the reference symbol (d) in FIG. 12, as shown in Table 4 and FIG. 12, it was possible to reduce the warpage of the single crystal substrate 50 of Sample 1 to 0. Note that, Spectrum A in FIG. 12 corresponds to Comparative Example, Spectrum B corresponds to Sample 2, and Spectrum C corresponds to Sample 1.

In addition, it was possible to confirm that, during the film formation step for the n-GaN layer indicated by the reference symbol (c) in FIG. 12, as shown in Table 4 and FIG. 12, it was possible to reduce the warpage of the single crystal substrate 50 of Sample 2 to 0 as the average value during the entire period of this film formation step.

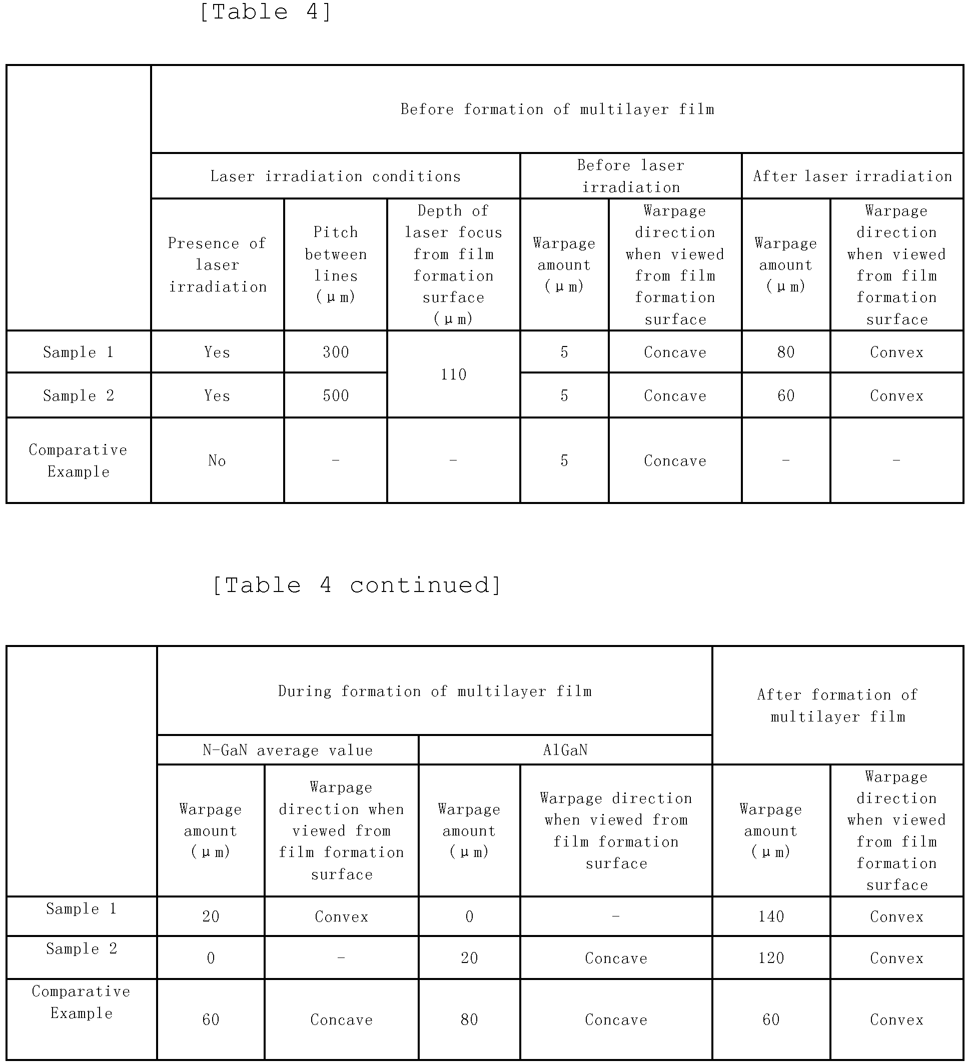

### <Example 3>

As shown in Table 5, among three conventional sapphire substrates on which no pre-process was performed (sapphire substrates before laser processing) (Samples 1 to 3), only one sapphire substrate was provided with the heat-denatured layer 20 by performing the laser irradiation process in the first region before the formation of the multilayer film, to thereby produce the sapphire substrate after laser processing of Sample 3. Next, the multilayer film was formed on the sapphire substrates before laser processing of Samples 1 and 2 and the sapphire substrate after laser processing of Sample 3.

On the sapphire substrates before laser processing of Samples 1 and 2, an LT-GaN film and an AlN filmwas formed, respectively. On the other hand, on the sapphire substrate after laser processing of Sample 3, the AlN film was formed. FIG. 11 shows the warpage behavior of the sapphire substrate during the formation of each of the LT-GaN film and the AlN film. At this time, evaluation was performed on the warpage amounts and the warpage directions, when viewed from the side of the surface on which the multilayer film was to be formed, of the sapphire substrate before and after the laser irradiation before the formation of the AlN film, and on the warpage amount and the warpage direction, when viewed from the film formation surface side, after the formation of the multilayer film. Hereinbelow, test conditions and evaluation results are described in detail. Note that, the sapphire substrate to be used and the formation conditions for the heat-denatured layer were the same as those in Example 1 described above. In addition, regarding the film formation conditions for the LT-GaN film or the AlN film, after thermal cleaning and the formation of the low-temperature buffer layer similar to those of Example 1 were performed, the LT-GaN film or the AlN film was formed.

### (Evaluation result)

### -Evaluation on warpage amount and warpage direction-

Table 5 shows the results of evaluation on the warpage amounts and the warpage directions, when viewed from the side of the surface on which the multilayer film was to be formed, before and after the laser irradiation before the formation of the AlN film, and on the warpage amount and the warpage direction, when viewed from the film formation surface side, after the formation of the AlN film, as Sample 3 (processed substrate before epitaxial growth + AlN). In addition, as comparative examples, Table 5 shows Sample 1 (STD+LT-GaN) in which the LT-GaN film was formed on the conventional sapphire substrate (sapphire substrate before laser processing) and Sample 2 (STD + AlN) in which the AlN film was formed on the conventional sapphire substrate.

As shown in Table 5, in each of Sample 1 (STD + LT-GaN) and Sample 2 (STD + AlN) in which the laser processing before the film formation was not performed, the sapphire substrate was warped convexly toward the film formation surface side after the film formation, and the warpage amount was 60 µm or 80 µm. However, in Sample 3 (processed substrate before epitaxial growth + AlN) in which the AlN film was formed by using the sapphire substrate after laser processing, the warpage amount was reduced to 10 µm. In particular, it was found that, in spite of the formation of the same AlN film, it was possible to reduce the warpage amount of the sapphire substrate after the film formation to one eighth of that of Sample 2.

**[Table 5]**

| Sample No. | Before film formation | | | | | | | |
|---|---|---|---|---|---|---|---|---|
| | Formation position of heat-denatured layer from first region side (µm) | Process pitch (µm) | Before being rocessed | | After being processed | | After film formation | |
| | | | Warpage (µm) | Shape | Warpage (µm) | Shape | Warpage (µm) | Shape |
| Sample 1 (STD +LT-GaN) | - | - | 5 | Concave | - | | 60 | Convex |
| Sample 2 (STD +AlN) | - | - | 5 | Concave | - | | 80 | Convex |
| Sample 3 (processed substrate before epitaxial growth +AlN) | 110 | 500 | 5 | Concave | 70 | Convex | 10 | Convex |

## Claims

1. A single crystal substrate, comprising a heat-denatured layer provided in one of two regions including a first region and a second region obtained by bisecting the single crystal substrate in a thickness direction of the single crystal substrate,
wherein the single crystal substrate is warped convexly toward a side of a surface of the one of the two regions provided with the heat-denatured layer.

2. A single crystal substrate according to claim 1, wherein the one of the two regions provided with the heat-denatured layer comprises the first region.

3. A single crystal substrate according to claim 1, wherein the one of the two regions provided with the heat-denatured layer comprises the second region.

4. A single crystal substrate according to claim 1 or 2, wherein, when a relative position of the heat-denatured layer in the thickness direction of the single crystal substrate is assumed to be 0% at a surface on a side of the first region and 100% at a surface on a side of the second region, the heat-denatured layer is provided in a range of 5% or more and less than 50% in the thickness direction of the single crystal substrate.

5. A single crystal substrate according to claim 1 or 3, wherein, when a relative position of the heat-denatured layer in the thickness direction of the single crystal substrate is assumed to be 0% at a surface on a side of the first region and 100% at a surface on a side of the second region, the heat-denatured layer is provided in a range of more than 50% and 95% or less in the thickness direction of the single crystal substrate.

6. A single crystal substrate according to any one of claims 1 to 5, wherein the heat-denatured layer is formed by laser irradiation.

7. A single crystal substrate according to any one of claims 1 to 6, wherein the heat-denatured layer is provided in parallel to both surfaces of the single crystal substrate.

8. A single crystal substrate according to any one of claims 1 to 7, wherein, in a planar direction of the single crystal substrate, the heat-denatured layer is provided to have at least one pattern shape selected from the following shapes:
i) a shape in which a plurality of polygons identical in shape and size are regularly disposed;
ii) a shape in which a plurality of circles or ellipses identical in shape and size are regularly disposed;
iii) a concentric shape;
iv) a shape formed so as to be substantially point-symmetric with respect to a center point of the single crystal substrate;
v) a shape formed so as to be substantially linearly-symmetric with respect to a straight line passing through the center point of the single crystal substrate;
vi) a stripe shape; and
vii) a spiral shape.

9. A single crystal substrate according to claim 8, wherein the shape in which the plurality of polygons identical in shape and size are regularly disposed comprises a lattice shape.

10. A single crystal substrate according to claim 9, wherein the lattice shape is formed of a pattern in which a pitch between lines constituting the pattern is in a range of 50 µm to 2,000 µm.

11. A single crystal substrate according to any one of claims 1 to 10, wherein the single crystal substrate has a curvature in a range of 200 km⁻¹ or less.

12. A single crystal substrate according to any one of claims 1 to 11, wherein a material of the single crystal substrate comprises sapphire.

13. A single crystal substrate according to any one of claims 1 to 12, wherein the single crystal substrate has a diameter of 50 mm or more and 300 mm or less.

14. A single crystal substrate according to any one of claims 1 to 13, wherein the single crystal substrate has a thickness of 0.05 mm or more and 5.0 mm or less.

15. A manufacturing method for a single crystal substrate, comprising performing at least a heat-denatured layer formation step in which a heat-denatured layer is formed in one of two regions including a first region and a second region obtained by bisecting a single crystal substrate in a thickness direction of the single crystal substrate, the heat-denatured layer being formed by irradiating a laser from a side of one surface of the single crystal substrate before a laser irradiation process, thereby manufacturing the single crystal substrate which is warped convexly toward a side of a surface of the one of the two regions provided with the heat-denatured layer.

16. A manufacturing method for a single crystal substrate according to claim 15, wherein the region provided with the heat-denatured layer comprises the first region.

17. Manufacturing method for a single crystal substrate according to claim 16, wherein the performing at least a heat-denatured layer formation step comprises irradiating the laser to the single crystal substrate from a surface of the single crystal substrate on a side of the first region.

18. A manufacturing method for a single crystal substrate according to claim 15, wherein the region provided with the heat-denatured layer comprises the second region.

19. A manufacturing method for a single crystal substrate according to claim 18, wherein the performing at least a heat-denatured layer formation step comprises irradiating the laser to the single crystal substrate from a surface of the single crystal substrate on a side of the second region.

20. A manufacturing method for a single crystal substrate according to any one of claims 15 to 19, wherein the performing at least a heat-denatured layer formation step comprises performing the laser irradiation so as to satisfy at least one of irradiation conditions A and B described below.
<Irradiation Condition A>
• laser wavelength: 200 nm to 350 nm
• pulse width: order of nanoseconds
<Irradiation Condition B>
• laser wavelength: 350 nm to 2,000 nm
• pulse width: order of femtoseconds to order of picoseconds

21. A manufacturing method for a single crystal substrate with a multilayer film,
the single crystal substrate comprising a heat-denatured layer provided in one of two regions including a first region and a second region obtained by bisecting the single crystal substrate in a thickness direction of the single crystal substrate,
the single crystal substrate being warped convexly toward a side of a surface of the one of the two regions provided with the heat-denatured layer,
the manufacturing method comprising performing at least a multilayer film formation step in which a multilayer film including two or more layers is formed on a surface of the single crystal substrate on a side of the second region.

22. A manufacturing method for a single crystal substrate with a multilayer film according to claim 21, wherein the one of the two regions provided with the heat-denatured layer comprises the first region.

23. A manufacturing method for a single crystal substrate with a multilayer film according to claim 21 or 22, wherein the performing at least a multilayer film formation step comprises forming the heat-denatured layer, when a relative position of the heat-denatured layer in the thickness direction of the single crystal substrate is assumed to be 0% at a surface on a side of the first region and 100% at a surface on a side of the second region, so as to be positioned in a range of 5% or more and less than 50% in the thickness direction of the single crystal substrate.

24. A manufacturing method for a single crystal substrate with a multilayer film according to claim 21, wherein the one of the two regions provided with the heat-denatured layer comprises the second region.

25. A manufacturing method for a single crystal substrate with a multilayer film according to claim 21 or 24, wherein the performing at least a multilayer film formation step comprises forming the heat-denatured layer, when a relative position of the heat-denatured layer in the thickness direction of the single crystal substrate is assumed to be 0% at a surface on a side of the first region and 100% at a surface on a side of the second region, so as to be positioned in a range of more than 50% and 95% or less in the thickness direction of the single crystal substrate.

26. A manufacturing method for a single crystal substrate with a multilayer film according to any one of claims 21 to 23, the manufacturing method comprising:
performing at least a heat-denatured layer formation step in which the heat-denatured layer is formed in the first region of the two regions including the first region and the second region obtained by bisecting the single crystal substrate in the thickness direction of the single crystal substrate, the heat-denatured layer being formed by irradiating a laser from a side of one surface of the single crystal substrate, thereby producing the single crystal substrate which is warped convexly toward the side of the surface of the first region; and
thereafter performing the multilayer film formation step on the single crystal substrate.

27. A manufacturing method for a single crystal substrate with a multilayer film according to claim 26, wherein the performing at least a heat-denatured layer formation step comprises irradiating the laser to the single crystal substrate from the surface of the single crystal substrate on the side of the first region.

28. A manufacturing method for a single crystal substrate with a multilayer film according to any one of claims 21, 24, and 25, the manufacturing method comprising:
performing at least a heat-denatured layer formation step in which the heat-denatured layer is formed in the second region of the two regions including the first region and the second region obtained by bisecting the single crystal substrate in the thickness direction of the single crystal substrate, the heat-denatured layer being formed by irradiating a laser from a side of one surface of the single crystal substrate, thereby producing the single crystal substrate which is warped convexly toward the side of the surface of the second region; and
thereafter performing the multilayer film formation step on the single crystal substrate.

29. A manufacturing method for a single crystal substrate with a multilayer film according to claim 28, wherein the performing at least a heat-denatured layer formation step comprises irradiating the laser to the single crystal substrate from the surface of the single crystal substrate on the side of the second region.

30. A manufacturing method for a single crystal substrate with a multilayer film according to any one of claims 26 to 29, wherein the performing at least a multilayer film formation step comprises performing the laser irradiation so as to satisfy at least one of irradiation conditions A and B described below.
<Irradiation Condition A>
• laser wavelength: 200 nm to 350 nm
• pulse width: order of nanoseconds
<Irradiation Condition B>
• laser wavelength: 350 nm to 2,000 nm
• pulse width: order of femtoseconds to order of picoseconds

31. A manufacturing method for a single crystal substrate with a multilayer film according to any one of claims 21 to 30, wherein the performing at least a multilayer film formation step comprises forming the heat-denatured layer so as to be in parallel to the multilayer film.

32. A manufacturing method for a single crystal substrate with a multilayer film according to any one of claims 21 to 31, wherein the performing at least a multilayer film formation step comprises forming, in a planar direction of the single crystal substrate, the heat-denatured layer so as to have at least one pattern shape selected from the following shapes:
i) a shape in which a plurality of polygons identical in shape and size are regularly disposed;
ii) a shape in which a plurality of circles or ellipses identical in shape and size are regularly disposed;
iii) a concentric shape;
iv) a shape formed so as to be substantially point-symmetric with respect to a center point of the single crystal substrate;
v) a shape formed so as to be substantially linearly-symmetric with respect to a straight line passing through the center point of the single crystal substrate;
vi) a stripe shape; and
vii) a spiral shape.

33. A manufacturing method for a single crystal substrate with a multilayer film according to claim 32, wherein the shape in which the plurality of polygons identical in shape and size are regularly disposed comprises a lattice shape.

34. A manufacturing method for a single crystal substrate with a multilayer film according to claim 33, wherein the performing at least a multilayer film formation step comprises forming the lattice shape into a pattern in which a pitch between lines constituting the pattern is in a range of 50 µm to 2,000 µm.

35. A manufacturing method for a single crystal substrate with a multilayer film according to any one of claims 21 to 34, wherein the single crystal substrate provided with the heat-denatured layer before the formation of the multilayer film has a curvature in a range of 200 km⁻¹ or less.

36. A manufacturing method for a single crystal substrate with a multilayer film according to any one of claims 21 to 35, wherein a material of the single crystal substrate comprises sapphire.

37. A manufacturing method for a single crystal substrate with a multilayer film according to any one of claims 21 to 36, wherein the single crystal substrate has a diameter of 50 mm or more and 300 mm or less.

38. A manufacturing method for a single crystal substrate with a multilayer film according to any one of claims 21 to 37, wherein the single crystal substrate has a thickness of 0.05 mm or more and 5.0 mm or less.

39. A manufacturing method for a single crystal substrate with a multilayer film according to any one of claims 21 to 38, wherein at least one of the two or more layers constituting the multilayer film comprises a nitride semiconductor crystal layer.

40. An element manufacturing method, comprising:
performing at least a multilayer film formation step in which a multilayer film including two or more layers is formed on a surface of a single crystal substrate on a side of a second region, thereby manufacturing a single crystal substrate with a multilayer film,
the single crystal substrate comprising a heat-denatured layer provided in one of two regions including a first region and the second region obtained by bisecting the single crystal substrate in a thickness direction of the single crystal substrate,
the single crystal substrate being warped convexly toward a side of a surface of the one of the two regions provided with the heat-denatured layer; and
performing at least an element portion formation step of performing at least a patterning process on the multilayer film of the single crystal substrate with a multilayer film to produce an element portion functioning as an element selected from the group consisting of a light emitting element, a photovoltaic element, and a semiconductor element, thereby manufacturing the element including the element portion and the single crystal substrate having a size substantially corresponding to a size of the element portion.
